(19) **Europäisches Patentamt / European Patent Office / Office européen des brevets**

(11) **EP 4 776 536 A1**

(12) # EUROPEAN PATENT APPLICATION
published in accordance with Art. 153(4) EPC

(43) Date of publication:
**15.07.2026 Bulletin 2026/29**

(21) Application number: **23955191.4**

(22) Date of filing: **13.10.2023**

(51) International Patent Classification (IPC):
**H04L 1/00** (2006.01)

(52) Cooperative Patent Classification (CPC):
**H04L 1/00**

(86) International application number:
**PCT/CN2023/124496**

(87) International publication number:
**WO 2025/076814 (17.04.2025 Gazette 2025/16)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **HUAWEI TECHNOLOGIES CO., LTD.**
**Shenzhen 518129 (CN)**

(72) Inventors:
• **QIN, Kangjian**
**Shenzhen, Guangdong 518129 (CN)**

• **ZHANG, Huazi**
**Shenzhen, Guangdong 518129 (CN)**
• **TONG, Jiajie**
**Shenzhen, Guangdong 518129 (CN)**
• **WANG, Xianbin**
**Shenzhen, Guangdong 518129 (CN)**
• **LIU, Ke**
**Shenzhen, Guangdong 518129 (CN)**
• **WANG, Jun**
**Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **COMMUNICATION METHOD AND APPARATUS**

(57)    This application belongs to the field of communication technologies, and provides a communication method and apparatus, to meet communication requirements in different service scenarios. In this method, a transmitting side may dynamically determine a first code block segmentation length based on a number of information columns of a base matrix and a lifting size in a set of lifting sizes corresponding to the base matrix, to segment a to-be-transmitted data block. Compared with an existing code block segmentation manner in which the transmitting side directly uses a preselected fixed length $K_{cb}=3840$ or $K_{cb}=8448$ for segmentation, in this manner, the first code block segmentation length may be dynamically adjusted based on service scenario requirements. This implementation is more flexible, and can avoid errors or inapplicability of code block segmentation. Therefore, code block segmentation accuracy and communication reliability can be improved, to meet communication requirements in different service scenarios.

FIG. 4

## Description

### TECHNICAL FIELD

This application relates to the communication field, and in particular, to a communication method and apparatus.

### BACKGROUND

Low-density parity-check (low-density parity check code, LDPC) codes are a type of linear block codes with a sparse parity-check matrix. They not only have good performance approaching the Shannon (Shannon) limit, but also feature low decoding complexity and a flexible structure. Low-density parity-check codes have been adopted by the 3rd generation partnership project (3rd generation partnership project, 3GPP) as a coding scheme for 5th generation (5th generation, 5G) data channels. A code block segmentation (code block segmentation, CB segmentation) manner used is as follows: a code block segmentation length $K_{cb}$ is determined based on a selected base matrix (base graph, BG), and a to-be-transmitted data block is segmented accordingly using $K_{cb}$. segmented based on 8448; or if a BG 2 is selected, the to-be-transmitted data block is segmented based on.

However, in some new service scenarios such as those requiring highly reliable and/or low-latency connections, the existing code block segmentation manner may be prone to errors or unsuitable. How to meet communication requirements in different service scenarios is an urgent technical problem to be resolved.

### SUMMARY

Embodiments of this application provide a communication method and apparatus, to meet communication requirements in different service scenarios.

The following technical solutions are used in this application.

According to a first aspect, a communication method is provided. The method may be performed by a transmitting device. Unless otherwise specified, the "transmitting device" in embodiments of this application may be the transmitting device (for example, a network device or a terminal device), may be a component (for example, a processor, a chip, or a chip system) in the transmitting device, or may be a logical module or software that can implement all or a part of functions of the transmitting device. The method includes: determining a first code block segmentation length, segmenting a to-be-transmitted data block based on the first code block segmentation length, and performing LDPC encoding on the segmented to-be-transmitted data block to obtain encoded data. The first code block segmentation length is used to perform code block segmentation on the to-be-transmitted data block. The first code block segmentation length is determined based on a number of information columns of a base matrix and a lifting size in a set of lifting sizes corresponding to the base matrix. The base matrix is used to perform low-density parity-check code LDPC encoding on the to-be-transmitted data block.

It can be learned from the method according to the first aspect that a transmitting side may dynamically determine the first code block segmentation length based on the number of information columns of the base matrix and the lifting size in the set of lifting sizes corresponding to the base matrix, to segment the to-be-transmitted data block. Compared with an existing code block segmentation manner in which the transmitting side directly uses a preselected fixed length $K_{cb}$=3840 or $K_{cb}$=8448 for segmentation, in this manner, the first code block segmentation length may be dynamically adjusted based on service scenario requirements. This implementation is more flexible, and can avoid errors or inapplicability of code block segmentation. Therefore, code block segmentation accuracy and communication reliability can be improved, to meet communication requirements in different service scenarios.

In a possible design solution, the first code block segmentation length satisfies the following relationship: $K_{cb}=K_b \times Z_c$, where $K_{cb}$ is the first code block segmentation length, $K_b$ is the number of information columns, and $Z_c$ is the lifting size. In other words, the first code block segmentation length is a product of the number of information columns and the lifting size. Therefore, the first code block segmentation length can be accurately determined, improving the code block segmentation accuracy.

In a possible design solution, a code rate is less than or equal to a first code rate, the number of information columns is determined based on a minimum code rate and a maximum number of information columns, the code rate is greater than or equal to the minimum code rate, and the number of information columns is less than or equal to the maximum number of information columns. The first code rate may be a preset value, for example, 1/3. This is not limited. In other words, in a low rate service scenario, for example, an ultra-reliable and low-latency connection service scenario, the number of information columns may be determined based on the minimum code rate and the maximum number of information columns, to be applicable to the low rate service scenario.

Optionally, the number of information columns satisfies any one of the following relationships:

$$R_{min} = \frac{K_b}{K_b+K_{b\max}-2}, \quad K_b = \left\lfloor (K_{b\max} - 2)\left(\frac{R_{min}}{1-R_{min}}\right)\right\rfloor, \quad K_b = \left\lceil (K_{b\max} - 2)\left(\frac{R_{min}}{1-R_{min}}\right)\right\rceil,$$

or

$$K_b = (K_{b\max} - 2)\left(\frac{R_{min}}{1-R_{min}}\right).$$

$R_{min}$ is the minimum code rate. $K_b$ is the number of information columns. $K_{b\max}$ is the maximum number of information columns. Values of $R_{min}$ and $K_{b\max}$ may be preset values. In this way, the number of information columns in the low rate service scenario can be accurately determined, improving the code block segmentation accuracy.

In a possible design solution, the number of information columns is determined based on a code rate, to be applicable to a high throughput service scenario.

Optionally, a relationship between the number of information columns and the code rate satisfies any one of the following: When the code rate is less than or equal to 0.875, a value of the number of information columns is 14; when the code rate is greater than 0.875 and less than or equal to 0.9, a value of the number of information columns is 18; when the code rate is greater than 0.9 and less than or equal to 0.917, a value of the number of information columns is 22; or when the code rate is greater than 0.917 and less than or equal to 0.926, a value of the number of information columns is 26. In this way, the transmitting side can accurately determine, based on a value range of the code rate, the number of information columns in the high throughput service scenario, improving the code block segmentation accuracy.

In a possible design solution, the number of information columns is a preset value, that is, the number of information columns may be predefined or preconfigured. The transmitting side may directly determine the first code block segmentation length by using the predefined or preconfigured number of information columns. An implementation process is simple.

In a possible design solution, the lifting size is a preset value, that is, the lifting size may be predefined or preconfigured. The transmitting side may directly determine the first code block segmentation length by using the predefined or preconfigured lifting size. An implementation process is simple.

In a possible design solution, corresponding to sending of the to-be-transmitted data block by a terminal device to a network device, the lifting size is a first lifting size. Alternatively, corresponding to sending of the to-be-transmitted data block by a network device to a terminal device, the lifting size is a second lifting size. A maximum value of the first lifting size is greater than a maximum value of the second lifting size.

It may be understood that decoding capabilities of the network device and the terminal device are different, and a maximum decoding code length that can be supported by the network device is greater than a maximum decoding code length that can be supported by the terminal device. Therefore, the maximum value of the first lifting size is greater than the maximum value of the second lifting size. The transmitting side may flexibly select the lifting size based on whether the to-be-transmitted data block is an uplink data block or a downlink data block, to match a decoding capability of a receiving side. This improves encoding efficiency of the transmitting side and decoding efficiency of the receiving side, further improving communication efficiency.

Optionally, a number of values of the first lifting size is greater than a number of values of the second lifting size. For example, optionally, the value of the first lifting size is any one of the following: 416, 448, 512, 1024, 115, 1536, 1920, or 2048; and the value of the second lifting size is any one of the following: 384 or 512. In this way, the terminal device may determine one of the values of the first lifting size as a lifting size on an uplink data channel, or the network device may determine one of the values of the second lifting size as a lifting size on a downlink data channel, to subsequently determine a corresponding first code block segmentation length.

In a possible design solution, corresponding to a first communication service type, the first communication service type satisfies any one of the following: A number of bits included in the to-be-transmitted data block is less than or equal to a first bit value, and the code rate is less than or equal to a second code rate; or a mother code length is less than or equal to a first code length, and the code rate is less than or equal to a third code rate, where the mother code length is a code block length of the encoded to-be-transmitted data block. In this case, the transmitting side may encode the to-be-transmitted data block by using an LDPC code. A structure is flexible, and decoding complexity is low.

Optionally, corresponding to the base matrix including a first base graph BG 1, that the number of bits included in the to-be-transmitted data block is less than or equal to the first bit value, and the code rate is less than or equal to the second code rate includes: The number of bits included in the to-be-transmitted data block is greater than 3824, the number of bits included in the to-be-transmitted data block is less than or equal to 8448, the code rate is greater than 0.25, and the code rate is less than or equal to 0.67. Alternatively, the number of bits included in the to-be-transmitted data block is greater than 140, the number of bits included in the to-be-transmitted data block is less than or equal to 8448, the code rate is greater than 0.67, and the code rate is less than or equal to 0.9258. In other words, a region to which the BG 1 belongs may be clearly determined by using a constraint of the number of bits included in the to-be-transmitted data block and the code rate. When the number of bits included in the to-be-transmitted data block and the code rate belong to the region, the transmitting side may directly encode the to-be-transmitted data block by using the BG 1.

Optionally, corresponding to the base matrix including a second base graph BG 2, that the number K of bits included in the to-be-transmitted data block is less than or equal to the first bit value, and the code rate is less than or equal to the second code rate includes: The number of bits included in the to-be-transmitted data block is greater than 1024, the number of bits included in the to-be-transmitted data block is less than or equal to the third bit value 8448, and the code rate is less than or equal to 0.25. Alternatively, the number of bits included in the to-be-transmitted data block is greater than 1024, the number of bits included in the to-be-transmitted data block is less than or equal to 3824, the code rate is greater than 0.25, and the code rate is less than or equal to 0.5. Alternatively, the number of bits included in the to-be-transmitted data block is greater than 140, the number of bits included in the to-be-transmitted data block is less than or equal to 3824, the code rate is greater than 0.5, and the code rate is less than or equal to 0.67. In other words, a region to which the BG 2 belongs may be clearly determined by using a constraint of the number of bits included in the to-be-transmitted data block and the code rate. When the number of bits included in the to-be-transmitted data block and the code rate belong to the region, the transmitting side may directly encode the to-be-transmitted data block by using the BG 2.

Optionally, that the mother code length is less than or equal to the first code length, and the code rate is less than or equal to the third code rate includes: The mother code length is greater than 1024, the mother code length is less than or equal to 25344, and the code rate is less than or equal to 1/3. Alternatively, the mother code length is greater than 512, the mother code length is less than or equal to 25344, the code rate is greater than 1/3, and the code rate is less than or equal to 2/3. Alternatively, the mother code length is greater than 256, the mother code length is less than or equal to 25344, the code rate is greater than 2/3, and the code rate is less than or equal to 7/8. In other words, a region to which the LDPC code belongs may be clearly determined by using a constraint of the mother code length and the code rate. When the mother code length and the code rate belong to the region, the transmitting side may directly encode the to-be-transmitted data block by using the LDPC code.

In a possible design solution, the method according to the first aspect further includes: corresponding to a second communication service type, encoding the to-be-transmitted data block by using a polar code. A code rate for the second communication service type and the number of bits included in the to-be-transmitted data block satisfy at least one of the following: The number of bits included in the to-be-transmitted data block is less than or equal to a second bit value, and the code rate is less than or equal to a fourth code rate. In this case, the transmitting side may encode the to-be-transmitted data block by using the polar code, improving data channel decoding performance. The transmitting side does not need to perform code block segmentation on the to-be-transmitted data block.

Optionally, that the number of bits included in the to-be-transmitted data block is less than or equal to the second bit value, and the code rate is less than or equal to the fourth code rate includes: The number of bits included in the to-be-transmitted data block is less than or equal to 140, and the code rate is less than or equal to 0.9258. Alternatively, the number of bits included in the to-be-transmitted data block is greater than 140, the number of bits included in the to-be-transmitted data block is less than or equal to 1024, and the code rate is less than or equal to 0.5. In other words, a region to which the polar code belongs may be clearly determined by using the constraint of the number of bits included in the to-be-transmitted data block and the code rate. When the number of bits included in the to-be-transmitted data block and the code rate belong to the region, the transmitting side may directly encode the to-be-transmitted data block by using the polar code. Performance of the polar code is far better than that of the LDPC code, and the polar code has low computational complexity in terms of encoding and decoding. Therefore, data channel encoding and decoding performance can be improved.

In a possible design solution, the method according to the first aspect further includes: corresponding to a second communication service type, segmenting the to-be-transmitted data block; and encoding the to-be-transmitted data block by using a polar code. The second communication service type satisfies a condition that the mother code length is less than or equal to a second code length and the code rate is less than or equal to a fifth code rate, where the mother code length is the code block length of the encoded to-be-transmitted data block. In this case, the transmitting side may encode, by using the polar code, the to-be-transmitted data block subject to code block segmentation, improving data channel decoding performance.

Optionally, that the mother code length is less than or equal to the second code length and the code rate is less than or equal to the fifth code rate includes: The mother code length is less than or equal to 1024, and the code rate is less than or equal to 1/3. Alternatively, the mother code length is less than or equal to 512, the code rate is greater than 1/3, and the code rate is less than or 2/3. Alternatively, the mother code length is less than or equal to 256, the code rate is greater than 2/3, and the code rate is less than or equal to 7/8. In other words, a region to which the polar code belongs may be clearly determined by using the constraint of the mother code length and the code rate. When the mother code length and the code rate belong to the region, the transmitting side may directly encode the to-be-transmitted data block by using the polar code. Performance of the polar code is far better than that of the LDPC code, and the polar code has low computational complexity in terms of encoding and decoding. Therefore, data channel encoding and decoding performance can be improved.

Optionally, segmenting the to-be-transmitted data block includes: performing code block segmentation on the to-be-transmitted data block based on a second code block segmentation length, where the second code block segmentation length is determined based on the mother code length and the code rate. The transmitting side may flexibly adjust the second code block segmentation length based on the mother code length and the code rate, to meet requirements in different service scenarios. This improves reliability of a code block segmentation process, improving the communication reliability.

Optionally, the second code block segmentation length satisfies the following relationship: $A=\lceil N_{max} \cdot R \rceil$, where A is the second code block segmentation length, $N_{max}$ is the mother code length, and R is the code rate. In other words, the first code block segmentation length is a product of the mother code length and the code rate. Therefore, the second code block segmentation length can be accurately determined, improving the code block segmentation accuracy.

According to a second aspect, a communication method is provided. The method may be performed by a transmitting device. Unless otherwise specified, the "transmitting device" in embodiments of this application may be the transmitting device (for example, a network device or a terminal device), may be a component (for example, a processor, a chip, or a chip system) in the transmitting device, or may be a logical module or software that can implement all or a part of functions of the transmitting device. The method includes: obtaining a lifting size of a base matrix, and encoding a segmented to-be-transmitted data block based on the lifting size. The lifting size is determined based on a code block segmentation length and a number of information columns of the base matrix. The code block segmentation length is a preset value. The base matrix is used to perform LDPC encoding on the to-be-transmitted data block.

It can be learned from the method according to the second aspect that a transmitting side may first determine the code block segmentation length based on a selected BG, and then dynamically adjust the lifting size of the base matrix by using the code block segmentation length and the number of information columns of the base matrix. In addition, the transmitting side encodes the segmented to-be-transmitted data block by using the lifting size of the base matrix. This implementation is more flexible, and can avoid occurrence of an error in an encoding process due to a small number of information columns. Therefore, data channel encoding accuracy can be improved, to meet requirements in different scenarios and improve communication efficiency.

In a possible design solution, the lifting size satisfies the following relationship: $Z_c=\lceil K_{cb}/K_b \rceil$, where $Z_c$ is the lifting size, $K_{cb}$ is the code block segmentation length, and $K_b$ is the number of information columns. In other words, the lifting size is a product of the code block segmentation length and the number of information columns. Therefore, the lifting size can be accurately determined, improving the data channel encoding accuracy.

In a possible design solution, the method according to the second aspect further includes: performing code block segmentation on the to-be-transmitted data block based on the code block segmentation length. In other words, the transmitting side may first perform code block segmentation on the to-be-transmitted data block based on the code block segmentation length, for subsequent LDPC encoding.

Optionally, a value of the code block segmentation length is related to a type of the base matrix. For example, if the base matrix is a first base matrix, the code block segmentation length is a first preset value, where the first preset value is 8448; or if the base matrix is a second base matrix, the code block segmentation length is a second preset value, where the second preset value is 3840. The transmitting side may determine, based on the type of the base matrix, that the code block segmentation length is 8448 or 3840, to subsequently perform code block segmentation on the to-be-transmitted data block by using 8448 or 3840.

In a possible design solution, the number of information columns is determined based on a minimum code rate and a maximum number of information columns, a code rate is greater than or equal to the minimum code rate, and the number of information columns is less than or equal to the maximum number of information columns. A first code rate may be a preset value, for example, 1/3. This is not limited.

Optionally, the number of information columns satisfies any one of the following relationships:

$$R_{min} = \frac{K_b}{K_b + K_{b\max} - 2}, \quad K_b = \left\lfloor (K_{b\max} - 2)\left(\frac{R_{min}}{1-R_{min}}\right)\right\rfloor, \quad K_b = \left\lceil (K_{b\max} - 2)\left(\frac{R_{min}}{1-R_{min}}\right)\right\rceil,$$

or

$$K_b = (K_{b\max} - 2)\left(\frac{R_{min}}{1-R_{min}}\right).$$

$R_{min}$ is the minimum code rate, $K_b$ is the number of information columns, and $K_{b\max}$ is the maximum number of information columns. Values of $R_{min}$ and $K_{b\max}$ may be preset values.

In a possible design solution, the number of information columns is determined based on a code rate.

Optionally, a relationship between the number of information columns and the code rate satisfies any one of the following: When the code rate is less than or equal to 0.875, a value of the number of information columns is 14; when the code rate is greater than 0.875 and less than or equal to 0.9, a value of the number of information columns is 18; when the code rate is greater than 0.9 and less than or equal to 0.917, a value of the number of information columns is 22; or when the code rate is greater than 0.917 and less than or equal to 0.926, a value of the number of information columns is 26.

In a possible design solution, the number of information columns may be a preset value.

In addition, for other technical effects of the method according to the second aspect, refer to the technical effects of the method according to the first aspect. Details are not described herein again.

According to a third aspect, a communication apparatus is provided. The communication apparatus may be used in the transmitting device in the first aspect, to implement a function performed by the transmitting device. The communication apparatus may be the transmitting device. Unless otherwise specified, the "transmitting device" in embodiments of this application may be the transmitting device (for example, a network device or a terminal device), may be a component (for example, a processor, a chip, or a chip system) in the transmitting device, or may be a logical module or software that can implement all or a part of functions of the transmitting device, for example, a transceiver module and a processing module. The transceiver module may independently complete the following receiving and sending operations, or may cooperate with the processing module to complete the following receiving and sending operations. Correspondingly, the processing module may independently complete the following processing operation, or may cooperate with the transceiver module to complete the following processing operation. This is not limited.

The processing module is configured to determine a first code block segmentation length, is further configured to segment a to-be-transmitted data block based on the first code block segmentation length, and is further configured to perform LDPC encoding on the segmented to-be-transmitted data block to obtain encoded data. The first code block segmentation length is used to perform code block segmentation on the to-be-transmitted data block. The first code block segmentation length is determined based on a number of information columns of a base matrix and a lifting size in a set of lifting sizes corresponding to the base matrix. The base matrix is used to perform LDPC encoding on the to-be-transmitted data block.

In a possible design solution, the first code block segmentation length satisfies the following relationship: $K_{cb} = K_b \times Z_c$, where $K_{cb}$ is the first code block segmentation length, $K_b$ is the number of information columns, and $Z_c$ is the lifting size.

In a possible design solution, a code rate is less than or equal to a first code rate, the number of information columns is determined based on a minimum code rate and a maximum number of information columns, the code rate is greater than or equal to the minimum code rate, and the number of information columns is less than or equal to the maximum number of information columns.

Optionally, the number of information columns satisfies any one of the following relationships:

$$R_{min} = \frac{K_b}{K_b + K_{b\max} - 2}, \quad K_b = \left\lfloor (K_{b\max} - 2)\left(\frac{R_{min}}{1 - R_{min}}\right)\right\rfloor, \quad K_b = \left\lceil (K_{b\max} - 2)\left(\frac{R_{min}}{1 - R_{min}}\right)\right\rceil,$$

or

$$K_b = (K_{b\max} - 2)\left(\frac{R_{min}}{1 - R_{min}}\right).$$

$R_{min}$ is the minimum code rate, $K_b$ is the number of information columns, and $K_{b\max}$ is the maximum number of information columns. Values of $R_{min}$ and $K_{b\max}$ may be preset values.

In a possible design solution, the number of information columns is determined based on a code rate.

Optionally, a relationship between the number of information columns and the code rate satisfies any one of the following: When the code rate is less than or equal to 0.875, a value of the number of information columns is 14; when the code rate is greater than 0.875 and less than or equal to 0.9, a value of the number of information columns is 18; when the code rate is greater than 0.9 and less than or equal to 0.917, a value of the number of information columns is 22; or when the code rate is greater than 0.917 and less than or equal to 0.926, a value of the number of information columns is 26.

In a possible design solution, the number of information columns is a preset value.

In a possible design solution, the number of information columns is a preset value.

In a possible design solution, corresponding to sending of the to-be-transmitted data block by a terminal device to a network device, the lifting size is a first lifting size. Alternatively, corresponding to sending of the to-be-transmitted data block by a network device to a terminal device, the lifting size is a second lifting size. A maximum value of the first lifting size is greater than a maximum value of the second lifting size.

Optionally, a number of values of the first lifting size is greater than a number of values of the second lifting size.

Optionally, the value of the first lifting size is any one of the following: 416, 448, 512, 1024, 115, 1536, 1920, or 2048. The value of the second lifting size is any one of the following: 384 or 512.

In a possible design solution, corresponding to a first communication service type, the first communication service type satisfies any one of the following: A number of bits included in the to-be-transmitted data block is less than or equal to a first bit value, and the code rate is less than or equal to a second code rate; or a mother code length is less than or equal to a first code length, and the code rate is less than or equal to a third code rate, where the mother code length is a code block length of the encoded to-be-transmitted data block.

Optionally, corresponding to the base matrix including a first base graph BG 1, that the number of bits included in the to-be-transmitted data block is less than or equal to the first bit value, and the code rate is less than or equal to the second code rate includes: The number of bits included in the to-be-transmitted data block is greater than 3824, the number of bits included in the to-be-transmitted data block is less than or equal to 8448, the code rate is greater than 0.25, and the code rate is less than or equal to 0.67. Alternatively, the number of bits included in the to-be-transmitted data block is greater than 140, the number of bits included in the to-be-transmitted data block is less than or equal to 8448, the code rate is greater than 0.67, and the code rate is less than or equal to 0.9258.

Optionally, corresponding to the base matrix including a second base graph BG 2, that the number K of bits included in the to-be-transmitted data block is less than or equal to the first bit value, and the code rate is less than or equal to the second code rate includes: The number of bits included in the to-be-transmitted data block is greater than 1024, the number of bits included in the to-be-transmitted data block is less than or equal to the third bit value 8448, and the code rate is less than or equal to 0.25. Alternatively, the number of bits included in the to-be-transmitted data block is greater than 1024, the number of bits included in the to-be-transmitted data block is less than or equal to 3824, the code rate is greater than 0.25, and the code rate is less than or equal to 0.5. Alternatively, the number of bits included in the to-be-transmitted data block is greater than 140, the number of bits included in the to-be-transmitted data block is less than or equal to 3824, the code rate is greater than 0.5, and the code rate is less than or equal to 0.67.

Optionally, that the mother code length is less than or equal to the first code length, and the code rate is less than or equal to the third code rate includes: The mother code length is greater than 1024, the mother code length is less than or equal to 25344, and the code rate is less than or equal to 1/3. Alternatively, the mother code length is greater than 512, the mother code length is less than or equal to 25344, the code rate is greater than 1/3, and the code rate is less than or equal to 2/3. Alternatively, the mother code length is greater than 4256, the mother code length is less than or equal to 25344, the code rate is greater than 2/3, and the code rate is less than or equal to 7/8.

In a possible design solution, corresponding to a second communication service type, the processing module is further configured to encode the to-be-transmitted data block by using a polar code. A code rate for the second communication service type and the number of bits included in the to-be-transmitted data block satisfy at least one of the following: The number of bits included in the to-be-transmitted data block is less than or equal to a second bit value, and the code rate is less than or equal to a fourth code rate.

Optionally, that the number of bits included in the to-be-transmitted data block is less than or equal to the second bit value, and the code rate is less than or equal to the fourth code rate includes: The number of bits included in the to-be-transmitted data block is less than or equal to 140, and the code rate is less than or equal to 0.9258. Alternatively, the number of bits included in the to-be-transmitted data block is greater than 140, the number of bits included in the to-be-transmitted data block is less than or equal to 1024, and the code rate is less than or equal to 0.5.

In a possible design solution, corresponding to a second communication service type, the processing module is further configured to segment the to-be-transmitted data block. The processing module is further configured to encode the to-be-transmitted data block by using a polar code. The second communication service type satisfies a condition that the mother code length is less than or equal to a second code length and the code rate is less than or equal to a fifth code rate, where the mother code length is the code block length of the encoded to-be-transmitted data block.

Optionally, that the mother code length is less than or equal to the second code length and the code rate is less than or equal to the fifth code rate includes: The mother code length is less than or equal to 1024, and the code rate is less than or equal to 1/3. Alternatively, the mother code length is less than or equal to 512, the code rate is greater than 1/3, and the code rate is less than or 2/3. Alternatively, the mother code length is less than or equal to 256, the code rate is greater than 2/3, and the code rate is less than or equal to 7/8.

Optionally, the processing module is further configured to perform code block segmentation on the to-be-transmitted data block based on a second code block segmentation length, where the second code block segmentation length is determined based on the mother code length and the code rate.

Optionally, the second code block segmentation length satisfies the following relationship: $A = \lceil N_{max} \cdot R \rceil$, where A is the second code block segmentation length, $N_{max}$ is the mother code length, and R is the code rate.

Optionally, the communication apparatus according to the third aspect may further include a storage module. The storage module stores a program or instructions. When the processing module executes the program or the instructions, the communication apparatus is enabled to perform the communication method according to the first aspect.

The communication apparatus according to the third aspect may be a terminal device or a network device, may be a component (for example, a processor, a chip, or a chip system) in a terminal device or a network device, or may be a logical module or software that can implement all or a part of functions of a terminal device or a network device. This is not limited in this application.

In addition, for technical effects of the communication apparatus according to the third aspect, refer to the technical effects of the communication method according to the first aspect. Details are not described herein again.

According to a fourth aspect, a communication apparatus is provided. The communication apparatus may be used in the transmitting device in the second aspect, to implement a function performed by the transmitting device. The communication apparatus may be the transmitting device. Unless otherwise specified, the "transmitting device" in embodiments of this application may be the transmitting device (for example, a network device or a terminal device), may be a component (for example, a processor, a chip, or a chip system) in the transmitting device, or may be a logical module or software that can implement all or a part of functions of the transmitting device, for example, a transceiver module and a processing module. The transceiver module may independently complete the following receiving and sending operations, or may cooperate with the processing module to complete the following receiving and sending operations. Correspondingly, the processing module may independently complete the following processing operation, or may cooperate with the transceiver module to complete the following processing operation. This is not limited.

The processing module is configured to obtain a lifting size of a base matrix, and is further configured to encode a segmented to-be-transmitted data block based on the lifting size. The lifting size is determined based on a code block segmentation length and a number of information columns of the base matrix. The code block segmentation length is a preset value. The base matrix is used to perform LDPC encoding on the to-be-transmitted data block.

In a possible design solution, the lifting size satisfies the following relationship: $Z_c = \lceil K_{cb}/K_b \rceil$, where $Z_c$ is the lifting size, $K_{cb}$ is the code block segmentation length, and $K_b$ is the number of information columns.

In a possible design solution, the processing module is further configured to perform code block segmentation on the to-be-transmitted data block based on the code block segmentation length.

Optionally, a value of the code block segmentation length is related to a type of the base matrix. For example, if the base matrix is a first base matrix, the code block segmentation length is a first preset value, where the first preset value is 8448; or if the base matrix is a second base matrix, the code block segmentation length is a second preset value, where the second preset value is 3840.

In a possible design solution, a code rate is less than or equal to a first code rate, the number of information columns is determined based on a minimum code rate and a maximum number of information columns, the code rate is greater than or equal to the minimum code rate, and the number of information columns is less than or equal to the maximum number of information columns. The first code rate may be a preset value.

Optionally, the number of information columns satisfies any one of the following relationships:

$$R_{min} = \frac{K_b}{K_b + K_{b\max} - 2}, \quad K_b = \left\lfloor (K_{b\max} - 2)\left(\frac{R_{min}}{1-R_{min}}\right)\right\rfloor, \quad K_b = \left\lceil (K_{b\max} - 2)\left(\frac{R_{min}}{1-R_{min}}\right)\right\rceil,$$

or

$$K_b = (K_{b\max} - 2)\left(\frac{R_{min}}{1-R_{min}}\right).$$

$R_{min}$ is the minimum code rate, $K_b$ is the number of information columns, and $K_{b\max}$ is the maximum number of information columns. Values of $R_{min}$ and $K_{b\max}$ may be preset values.

In a possible design solution, the number of information columns is determined based on a code rate.

Optionally, a relationship between the number of information columns and the code rate satisfies any one of the following: When the code rate is less than or equal to 0.875, a value of the number of information columns is 14; when the code rate is greater than 0.875 and less than or equal to 0.9, a value of the number of information columns is 18; when the code rate is greater than 0.9 and less than or equal to 0.917, a value of the number of information columns is 22; or when the code rate is greater than 0.917 and less than or equal to 0.926, a value of the number of information columns is 26.

In a possible design solution, the number of information columns may be a preset value.

Optionally, the communication apparatus according to the fourth aspect may further include a storage module. The storage module stores a program or instructions. When the processing module executes the program or the instructions, the communication apparatus is enabled to perform the communication method according to the second aspect.

The communication apparatus according to the fourth aspect may be a terminal device or a network device, may be a component (for example, a processor, a chip, or a chip system) in a terminal device or a network device, or may be a logical module or software that can implement all or a part of functions of a terminal device or a network device. This is not limited in this application.

In addition, for technical effects of the communication apparatus according to the fourth aspect, refer to the technical effects of the communication method according to the second aspect. Details are not described herein again.

According to a fifth aspect, a communication apparatus is provided, including a processor and a communication interface. The communication interface is configured to communicate with a module outside the communication apparatus. The processor is configured to execute a computer program or instructions, so that the communication apparatus performs the method according to the first aspect or the second aspect.

According to a sixth aspect, a communication apparatus (for example, the communication apparatus may be a chip or a chip system) is provided. The communication apparatus includes a processor, configured to implement functions in the first aspect or the second aspect.

In some possible designs, the communication apparatus includes a memory. The memory is configured to store necessary program instructions and/or data.

In a possible design solution, the processor may be integrated with the memory.

In some possible designs, when the communication apparatus is the chip system, the communication apparatus may include a chip, or may include a chip and another discrete component.

According to a seventh aspect, a communication apparatus is provided, including a transceiver and a processor. The transceiver is used by the communication apparatus to exchange information with another communication apparatus. The processor executes program instructions to perform the method according to the first aspect or the second aspect.

In a possible design solution, the communication apparatus according to the seventh aspect may further include a memory. The memory and the processor may be integrated together, or may be disposed separately. The memory may be configured to store a computer program and/or data related to the method according to the first aspect or the second aspect.

It should be understood that a corresponding module, unit, or means (means) for implementing the method according to the first aspect or the second aspect is included in the fifth aspect to the seventh aspect. The module, unit, or means may be implemented by using hardware, software, or hardware executing corresponding software. The hardware or the software includes one or more modules or units configured to perform functions in the foregoing methods.

It may be understood that when the communication apparatus according to any one of the fifth aspect to the seventh aspect is a chip, the foregoing sending action/function may be understood as outputting, and the foregoing receiving action/function may be understood as inputting.

According to an eighth aspect, a computer-readable storage medium is provided. The computer-readable storage medium stores a computer program or instructions. When the computer program or the instructions are run on a communication apparatus, the communication apparatus is enabled to perform the method according to the first aspect or the second aspect.

According to a ninth aspect, a computer program product including instructions is provided. When the computer program product is run on a communication apparatus, the communication apparatus is enabled to perform the method according to the first aspect or the second aspect.

According to a tenth aspect, an embodiment of this application provides a communication system. The communication system may include the communication apparatus according to any one of the possible designs of the first aspect or the second aspect.

## BRIEF DESCRIPTION OF DRAWINGS

FIG. 1A and FIG. 1B are diagrams of a structure of a base matrix corresponding to an NR LDPC code parity-check matrix;

FIG. 2 is a diagram of an architecture of a communication system according to an embodiment of this application;

FIG. 3 is a diagram of a structure of an encoding-decoding architecture according to an embodiment of this application;

FIG. 4 is a schematic flowchart 1 of a communication method according to an embodiment of this application;

FIG. 5 is a diagram 1 of region division corresponding to a data channel encoding mode;

FIG. 6 is a diagram 2 of region division corresponding to a data channel encoding mode;

FIG. 7 is a schematic flowchart 2 of a communication method according to an embodiment of this application;

FIG. 8 is a diagram 1 of a structure of a communication apparatus according to an embodiment of this application; and

FIG. 9 is a diagram 2 of a structure of a communication apparatus according to an embodiment of this application.

## DESCRIPTION OF EMBODIMENTS

For ease of understanding, the following first describes technical terms in embodiments of this application.

1. LDPC code parity-check matrix

LDPC codes are a type of linear block codes, and are determined by a sparse matrix H with M rows and N columns, where **H** includes an element 0 and an element 1. Since in the matrix only a small number of elements that are 1, most elements in the matrix are 0, the matrix is referred to as a sparse matrix. The sparse matrix **H** may also be referred to as the LDPC code parity-check matrix. **H** satisfies the following condition: Ratios of a row weight (a number of 1s in each row) and a column weight (a number of 1s in each column) of the matrix to a code length are far less than 1. Any two rows (columns) have at most one 1 in a same location. A number of linearly independent columns is as large as possible.

QC-LDPC codes are a subclass of the LDPC codes, and a QC-LDPC code parity-check matrix **H** has a cyclic characteristic. The QC-LDPC code parity-check matrix **H** may be generally represented as the following array:

$$\mathbf{H} = \begin{bmatrix} \mathbf{A}_{0,0} & \mathbf{A}_{0,1} & \cdots & \mathbf{A}_{0,c-1} \\ \mathbf{A}_{1,0} & \mathbf{A}_{1,1} & \cdots & \mathbf{A}_{1,c-1} \\ \vdots & \vdots & \ddots & \vdots \\ \mathbf{A}_{\rho-1,0} & \mathbf{A}_{\rho-1,1} & \cdots & \mathbf{A}_{\rho-1,c-1} \end{bmatrix}_{M \times N} ;$$

Each matrix $\mathbf{A}_{i,j}$ is a circulant matrix with a size of $Z \times Z$. If a number of rows and a number of columns of the parity-check matrix **H** are respectively denoted as $M = \rho Z$ and $N = cZ$, a length of a to-be-transmitted information sequence group is $K = N - M$. A transmitting side needs to encode the to-be-transmitted information sequence group by using the parity-check matrix, and a receiving side also needs to perform decoding based on the parity-check matrix. A design process of the QC-LDPC code relates to three important concepts: a circular permutation matrix (circular permutation matrix, CPM), a base pattern graph, and a base matrix (base graph, BG).

There are many methods for constructing the QC-LDPC code parity-check matrix. A possible method for constructing the quasi-cyclic LDPC code parity-check matrix is: First, a base matrix **B** with a size of $\rho \times c$ is constructed, for example:

$$\mathbf{B} = \begin{bmatrix} 1 & -1 & \cdots & 6 \\ -1 & 2 & \cdots & -1 \\ \vdots & \vdots & \ddots & \vdots \\ 4 & -1 & \cdots & 0 \end{bmatrix}_{\rho \times c} .$$

The base pattern graph of the QC-LDPC code is a matrix with a size the same as that of the base matrix, and elements of the matrix are either 0 or 1: "1" indicates that a shifting value (shifting value, which may also be referred to as a translation value) in a corresponding location of the base matrix is not equal to -1, and "0" indicates that the shifting value in the corresponding location of the base matrix is -1. For example, a base pattern graph of the base matrix in the foregoing

example is $\begin{bmatrix} 1 & 0 & \cdots & 1 \\ 0 & 1 & \cdots & 0 \\ \vdots & \vdots & \ddots & \vdots \\ 1 & 0 & \cdots & 1 \end{bmatrix}_{\rho \times c}$ .

Then, the non-"-1" elements in the base matrix B is extended into a circular permutation matrix with a size of $Z \times Z$, and the "-1" elements are extended into an all-zero matrix with a size of $Z \times Z$. If $\mathbf{P}^i$ represents a $Z \times Z$ circular permutation matrix, which is also referred to as a circulant submatrix of the base matrix, i is referred to as a shifting value of $\mathbf{P}^i$, for example,

$$\mathbf{P}^0 = \begin{bmatrix} 1 & 0 & 0 & \cdots & 0 \\ 0 & 1 & 0 & \cdots & 0 \\ 0 & 0 & 1 & \cdots & 0 \\ \vdots & \vdots & \vdots & \ddots & \vdots \\ 0 & 0 & 0 & \cdots & 1 \end{bmatrix}_{Z \times Z} , \quad \mathbf{P}^1 = \begin{bmatrix} 0 & 1 & 0 & \cdots & 0 \\ 0 & 0 & 1 & \cdots & 0 \\ 0 & 0 & 0 & \cdots & 0 \\ \vdots & \vdots & \vdots & \ddots & \vdots \\ 1 & 0 & 0 & \cdots & 0 \end{bmatrix}_{Z \times Z} , \quad \ldots .$$

For example, Z=8:

$$\mathbf{P^0} = \begin{bmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \end{bmatrix}, \mathbf{P^1} = \begin{bmatrix} 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \\ 1 & 0 & 0 & 0 & 0 & 0 & 0 & 0 \end{bmatrix}, ..., \mathbf{P^5} = $$

$$\begin{bmatrix} 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \\ 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \end{bmatrix}.$$

It can be learned that $\mathbf{P^0}$ is a unit matrix, and each circular permutation matrix $\mathbf{P^i}$ is actually obtained by cyclically shifting the unit matrix to the right by i bits. In addition, for a given Z, a total number of $\mathbf{P^i}$ is Z, that is, $i \in \{0, 1, 2, ..., Z-1\}$. Each $\mathbf{P^i}$ ($0 \leq i < Z$) is used to extend an element whose value is i in the base matrix B.

In this way, different parts of the base matrix B may be extracted based on different code rates and extended into corresponding check matrices, where a maximum size of a check matrix that may be obtained is $(\rho Z) \times (cZ)$. Therefore, a to-be-transmitted information sequence may be encoded and decoded at different code rates based on different check matrices obtained.

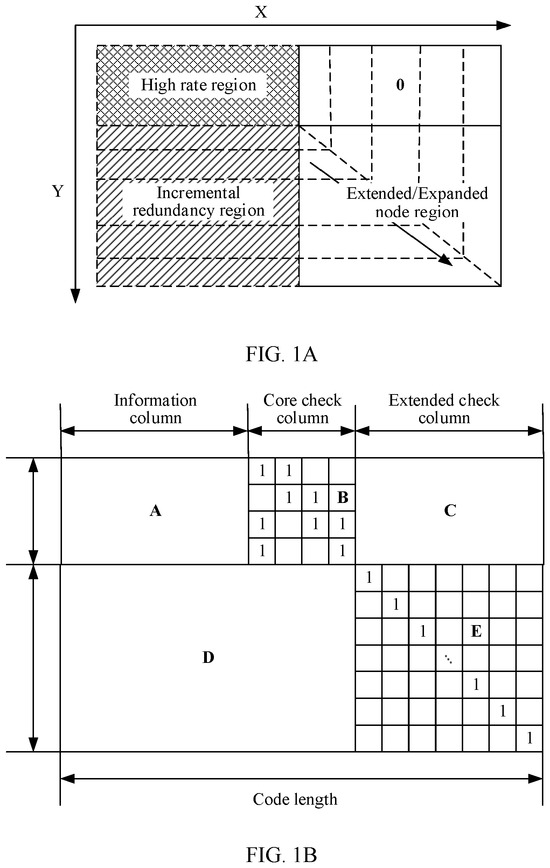

For example, FIG. 1A and FIG. 1B are diagrams of a structure of a base matrix corresponding to an NR LDPC code parity-check matrix according to an embodiment of this application. As shown in FIG. 1A, the base matrix is divided into a high rate region (high rate region), an incremental redundancy region (incremental redundancy region), a zero matrix region, and an extended/expanded node region (raptor-like region). During actual application, first X rows and first Y columns of the base matrix may be extracted. As X and Y gradually increase, the code rate decreases from high to low, so that a matrix region used is gradually expanded. Therefore, the extracted matrix part may be extended into a check matrix.

Further, FIG. 1B is a possible structure of the base matrix. As shown in FIG. 1B, A and B jointly form a high rate core matrix. A corresponds to a to-be-encoded information bit. B is a square matrix. The matrix B has a bidiagonal structure and corresponds to a check bit for a high code rate. C is an all-zero matrix. E is a unit matrix, and corresponds to a check bit for a low extended code rate. D and E jointly form a single-parity check relationship. At present, the 3GPP radio access network (radio access network, RAN) 1 stipulates that two base matrices whose lengths×widths are respectively 46×68 and 42×52 are used in an enhanced mobile bandwidth (enhanced mobile broadband, eMBB) scenario, to respectively support encoding of a large code length and a high code rate and encoding of a medium/small code length and a low code rate.

Because the NR LDPC code supports shortening (shorten by zero padding) and puncturing (puncture) operations in an encoding process, some base matrices of the NR LDPC code may further include a number of punctured information bits, a number of shortened information bits, a number of punctured check bits, and the like.

In embodiments of this application, an information bit is an information bit for LDPC encoding, and may be a to-be-sent information bit or a to-be-sent information bit including a cyclic redundancy check (cyclic redundancy check, CRC) check bit. This is not limited herein.

2. Polar code (polar code)

The polar code is an existing known channel coding scheme that can be rigorously proven to "achieve" a channel capacity, and features high performance and low complexity. Currently, the polar code has been adopted by the 3GPP as a control channel coding scheme for 5G control channel enhanced mobile bandwidth (enhanced mobile broadband, eMBB) scenarios (uplink/downlink).

The polar code is a first class of channel coding method that can be rigorously proved to "achieve" the channel capacity. For different code lengths, especially for finite-length codes, performance of the polar code is far better than that of LDPC codes. In addition, the polar code has low computational complexity in terms of encoding and decoding. These advantages enable the polar code to be widely used in 5G.

The polar code is a linear block code, a generator matrix is $G_N$, process is $x_1^N = \mu_1^N G_N$ .

$\mu_1^N = (\mu_1, \mu_{2\mu_2}, \dots, \mu_N)$ is a binary row vector with a length of N (that is, a code length). $G_N$ is an N×N matrix.

$G_N = F_2^{\otimes n}$, $F^2 = \begin{pmatrix} 1 & 0 \\ 1 & 1 \end{pmatrix}$, and n = log2(N). $F_2^{\otimes n}$ is a Kronecker (Kronecker) product of n matrices $F_2$.

In the encoding process of the polar code, one part of bits in $\mu_1^N$ are used to carry information, referred to as information bits, and a set of indexes of the bits is denoted as A. The other part of bits are set to fixed values pre-agreed upon by a transmitting side and a receiving side, referred to as fixed bits, and a set of indexes of the bits is represented by a complementary set $A^c$ of A.

3. Hybrid automatic repeat request (hybrid automatic repeat request, HARQ)

In communication applications insensitive to a system latency, HARQ is a common transmission method for improving a system throughput. When transmitting an information block, a transmitting side encodes the information block and sends the information block to a channel. If a receiving side finds that transmission fails (for example, cyclic redundancy check fails) after decoding a received signal, the receiving side transmits a negative acknowledgment (negative acknowledgment, NACK) message to the transmitting side through a feedback link. Then, the transmitting side retransmits the information block. This process continues until the receiving side correctly decodes the information block. In this case, the receiving side sends an acknowledgment (acknowledgment, ACK) message to the transmitting side, to complete transmission of the information block. To achieve an as high as possible link throughput, the receiving side buffers all received signals, and decodes the signals together with a new signal received.

4. Code block segmentation (code block segmentation, CB segmentation)

Code block segmentation is a process of segmenting a to-be-encoded bitstream, for example, a transport block (transport Block, TB), into shorter code blocks according to specific rules. Currently, an existing data channel uses LDPC encoding, and a CB segmentation manner for LDPC encoding is: first determining a BG based on a current payload size (a number of bits included in the transport block) and a code rate, and then performing segmentation based on a maximum number $K_{cb}$ of message bits corresponding to the BG. The BG may be classified as a BG 1 or a BG 2. A code rate range R supported by the BG 1 may be {1/3, 2/5, 1/2, 2/3, 3/4, 5/6 and 8/9}. A size of the BG 2 is 42×52, and a code rate range R supported by the BG 2 may be {1/5, 1/3, 2/5, 1/2, 2/3}. If the selected BG is the BG 1, a to-be-transmitted data block is segmented based on $K_{cb}$=8448; or if the selected BG is the BG 2, a to-be-transmitted data block is segmented based on $K_{cb}$=3840.

However, in some new service scenarios, the following problems may exist when a transmitting side uses the existing code block segmentation manner.

Problem A: In some new service scenarios, for example, service scenarios requiring high reliability and/or low latency for connections connection requirement such as high reliability and/or a low latency, the existing code block segmentation manner may be prone to errors or not applicable. How to meet communication requirements in different service scenarios is an urgent technical problem to be resolved.

For example, to support an ultra-reliable and low-latency connection service, the transmitting side may select a smaller number of information columns instead of reducing a code rate by increasing a number of redundant rows. In this case, a number of information columns corresponding to each segment of a CB may be small. For example, the number of information columns corresponding to each segment of the CB may be less than 6. In this case, a new BG may be introduced in LDPC, for example, a BG 3. To reduce a code rate to below 1/5, a number of information columns in the base graph may be selected to be 5.

In this case, if a number of message bits included in the to-be-transmitted data block is 7680, the BG 2 is selected according to the existing code block segmentation manner, and the to-be-transmitted data block is divided into two segments with a same length based on $K_{cb}$=3840. However, if the number of information columns is selected to be 5 for the BG 3, a maximum lifting size (lifting size $Z_c$) of the existing base matrix is 384. In this case, a maximum length of each segment of the CB is 1920, and this length is less than the existing segmentation length 3840. Therefore, code block segmentation needs to be performed again.

Problem B: In some new service scenarios, for example, a service scenarios requiring high reliability and/or low latency for connections, if the transmitting side still performs segmentation in the existing code block segmentation manner, an error may occur in an encoding process at the transmitting side, and consequently, data channel encoding accuracy is low.

For example, if a number of message bits in the to-be-transmitted data block is 7680, the BG 2 is selected according to the existing code block segmentation manner, and the to-be-transmitted data block is divided into two segments with a same length based on $K_{cb}$=3840. However, if the number of information columns is selected to be 5 for the BG 3, a maximum lifting size of the existing base matrix is 384. In this case, a maximum length of each segment of the CB is 1920, and this length is less than the existing segmentation length 3840. The transmitting side encodes each segment of the segmented CB by using 384, and consequently, an error occurs in the encoding process at the transmitting side.

In conclusion, for the foregoing technical problems, embodiments of this application provide the following technical solutions, to meet communication requirements in different service scenarios.

The following describes the technical solutions in embodiments of this application with reference to accompanying drawings.

The technical solutions in embodiments of this application may be applied to various communication systems, for example, a wireless fidelity (wireless fidelity, Wi-Fi) system, a vehicle-to-everything (vehicle-to-everything, V2X) communication system, a device-to-device (device-to-device, D2D) communication system, 4G such as a long term evolution (long term evolution, LTE) system, a worldwide interoperability for microwave access (worldwide interoperability for microwave access, WiMAX) communication system, 5G such as a new radio (new radio, NR) system, and a future communication system.

All aspects, embodiments, or features are presented in this application by describing a system that may include a plurality of devices, components, modules, and the like. It should be appreciated and understood that each system may include another device, component, module, and the like, and/or may not include all devices, components, modules, and the like discussed with reference to the accompanying drawings. In addition, a combination of these solutions may be used.

In addition, in embodiments of this application, the terms such as "example" or "for example" are for representing giving an example, an illustration, or a description. Any embodiment or design solution described as an "example" in this application should not be explained as being more preferred or having more advantages than another embodiment or design solution. Exactly, the term "example" is for presenting a concept in a specific manner.

In embodiments of this application, terms "information (information)", "signal (signal)", "message (message)", "channel (channel)", and "signaling (signaling)" may sometimes be interchangeably used. It should be noted that meanings expressed by the terms are matchable when differences of the terms are not emphasized. The terms "of (of)", "corresponding, relevant (corresponding, relevant)", and "corresponding (corresponding)" may sometimes be interchangeably used. It should be noted that meanings expressed by the terms are matchable when differences of the terms are not emphasized. In addition, "/" mentioned in this application may indicate an "or" relationship. It may be understood that in this application, an "indication" may include a direct indication, an indirect indication, an explicit indication, and an implicit indication. When a piece of indication information is described as indicating A, it may be understood as that the indication information carries A, directly indicates A, or indirectly indicates A.

In this application, information indicated by the indication information is referred to as to-be-indicated information. In a specific implementation process, there are many manners of indicating the to-be-indicated information. For example, the manners include but are not limited to: a manner in which the to-be-indicated information, for example, the to-be-indicated information or an index of the to-be-indicated information, may be directly indicated; a manner in which the to-be-indicated information may be indirectly indicated by indicating other information, where there is an association relationship between the other information and the to-be-indicated information; and a manner in which only one part of the to-be-indicated information may be indicated, and the other part of the to-be-indicated information is known or pre-agreed upon. For example, specific information may be indicated by using an arrangement sequence of a plurality of pieces of information that is pre-agreed upon (for example, stipulated in a protocol), to reduce indication overheads to some extent.

The to-be-indicated information may be sent as a whole, or may be divided into a plurality of pieces of sub-information for separate sending. In addition, sending periodicities and/or sending occasions of these pieces of sub-information may be the same or different. A specific sending method is not limited in this application. The sending periodicities and/or the sending occasions of these pieces of sub-information may be predefined, for example, predefined according to the protocol, or may be configured by a transmitting device by sending configuration information to a receiving device.

A network architecture and a service scenario described in embodiments of this application are intended to describe the technical solutions in embodiments of this application more clearly, and do not constitute a limitation on the technical solutions provided in embodiments of this application. A person of ordinary skill in the art may know that: With the evolution of the network architecture and the emergence of new service scenarios, the technical solutions provided in embodiments of this application are also applicable to similar technical problems.

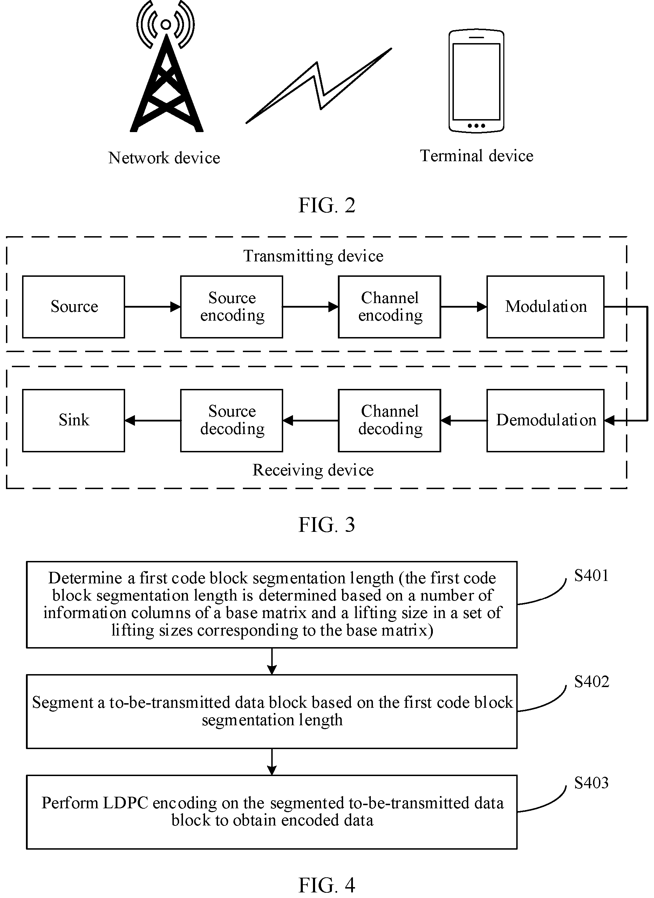

For ease of understanding embodiments of this application, a communication system shown in FIG. 2 is first used as an example to describe in detail a communication system applicable to embodiments of this application. For example, FIG. 2 is a diagram of an architecture of a communication system to which a communication method according to an embodiment of this application is applicable.

There may be a plurality of network devices, for example, a first network device, a second network device, and a third network device. The network device may be a device having a wireless transceiver function, or may be a chip or a chip system disposed in the device, and is located in an access network (access network, AN) of the communication system, to provide an access service for a terminal. For example, the network device may be referred to as a radio access network (radio access network, RAN) device, and may be specifically an access network device in a next-generation mobile communication system, for example, a 6G mobile communication system. For example, the network device may be a 6G base station. Alternatively, in the next-generation mobile communication system, the network device may be named in another manner, which falls within the protection scope of embodiments of this application. This is not limited in this application. Alternatively, the network device may include a gNB in 5G such as a new radio (new radio, NR) system, may include one antenna panel or a group of antenna panels (including a plurality of antenna panels) of a base station in 5G, or may be a network node that forms a gNB, a transmission point (a transmission and reception point, TRP, or a transmission point, TP), or a transmission measurement function (transmission measurement function, TMF). For example, the network device may be a central unit (central unit, CU), a distributed unit (distributed unit, DU), a CU-control plane (control plane, CP), a CU-user plane (user plane, UP), a radio unit (radio unit, RU), an RSU having a base station function, a wired access gateway, or a 5G core network element. Alternatively, the network device may include an access point (access point, AP), a wireless relay node, a wireless backhaul node, macro base stations in various forms, a micro base station (also referred to as a small cell), a relay station, an access point, a wearable device, a vehicle-mounted device, and the like in a wireless fidelity (wireless fidelity, Wi-Fi) system.

The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network CN. This is not limited herein.

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP and the CU-UP), the DU, and the RU in this application may be implemented by using a software module, a hardware module, or a combination of a software module and a hardware module.

A form of the network device is not limited in embodiments of this application. An apparatus configured to implement a function of the network device may be the network device, or may be an apparatus that can support the network device in implementing the function, for example, a chip system. The apparatus may be mounted in the network device or used in matching with the network device.

There may be one or more terminal devices, for example, a first terminal device, a second terminal device, and a third terminal device. The terminal device may be a terminal device having a transceiver function, or may be a chip or a chip system disposed in a terminal device. The terminal device may also be referred to as user equipment (user equipment, UE), an access terminal device, a subscriber unit (subscriber unit), a subscriber station, a mobile station (mobile station, MS), a remote station, a remote terminal device, a mobile device, a user terminal device, a terminal device, a wireless communication device, a user agent, or a user apparatus. The terminal device in embodiments of this application may be a mobile phone (mobile phone), a cellular phone (cellular phone), a smartphone (smartphone), a tablet computer (Pad), a wireless data card, a personal digital assistant (personal digital assistant, PDA) computer, a wireless modem (modem), a handheld device (handset), a laptop computer (laptop computer), a machine type communication (machine type communication, MTC) terminal device, a computer having a wireless transceiver function, a virtual reality (virtual reality, VR) terminal device, an augmented reality (augmented reality, AR) terminal device, a smart home device (for example, a refrigerator, a television, an air conditioner, or a meter), a smart robot, a robot arm, a workshop device, a wireless terminal device in self driving, a wireless terminal device in industrial control (industrial control), a wireless terminal device in self driving (self driving), a wireless terminal device in telemedicine (remote medical), a wireless terminal device in a smart grid (smart grid), a wireless terminal device in transportation safety (transportation safety), a wireless terminal device in a smart city (smart city), a wireless terminal device in a smart home (smart home), a vehicle-mounted terminal device, a roadside unit (roadside unit, RSU) or the like having a terminal device function, a flight device (for example, a smart robot, a hot air balloon, an uncrewed aerial vehicle, or an airplane), or the like. The terminal device in this application may alternatively be a vehicle-mounted module, a vehicle-mounted assembly, a vehicle-mounted component, a vehicle-mounted chip, or a vehicle-mounted unit that is built in a vehicle as one or more components or units. Alternatively, the terminal device may be another device having a terminal device function. For example, the terminal device may alternatively be a device that functions as a terminal device in D2D communication.

A form of the terminal device is not limited in embodiments of this application. An apparatus configured to implement a function of the terminal device may be the terminal device, or may be an apparatus that can support the terminal device in implementing the function, for example, a chip system. The apparatus may be mounted in the terminal device or used in matching with the terminal device. In embodiments of this application, the chip system may include a chip, or may include a chip and another discrete component.

In the communication system, a transmitting side may dynamically determine a first code block segmentation length based on a number of information columns of a base matrix and a lifting size in a set of lifting sizes corresponding to the base matrix, to segment a to-be-transmitted data block. Compared with an existing code block segmentation manner in which the transmitting side directly uses a preselected fixed length $K_{cb}$=3840 or $K_{cb}$=8448 for segmentation, in this manner, the first code block segmentation length may be dynamically adjusted based on service scenario requirements. This implementation is more flexible, and can avoid errors or inapplicability of code block segmentation. Therefore, code block segmentation accuracy and communication reliability can be improved, to meet communication requirements in different service scenarios.

It may be understood that FIG. 2 is a simplified diagram used as an example for ease of understanding. The communication system may further include another network device and/or another terminal device that are/is not shown in FIG. 2.

For example, FIG. 3 is a diagram of a structure of an encoding-decoding architecture according to an embodiment of this application. As shown in FIG. 3, a transmitting device performs source encoding, channel encoding, and modulation processing on source data to obtain encoded data, and sends the encoded data to a receiving device by using a radio channel. Correspondingly, the receiving device may perform demodulation, channel decoding, and source decoding on the received encoded data to obtain sink data. The transmitting device may be the network device shown in FIG. 2, and the receiving device may be the terminal device shown in FIG. 2. Alternatively, the transmitting device may be the terminal device shown in FIG. 2, and the receiving device may be the network device shown in FIG. 2.

It should be understood that FIG. 3 is merely a simple example. During specific implementation, other possible steps may be further added to FIG. 3, for example, radio network temporary identifier (radio network temporary identifier, RNTI) scrambling, rate matching, descrambling, and de-rate matching. This is not specifically limited.

In embodiments of this application, an encoding and modulation process or a decoding and demodulation process may be implemented by using an application-specific integrated circuit (application-specific integrated circuit, ASIC) chip or a field programmable gate array (field programmable gate array, FPGA) chip, or may be implemented by using software (program code in a memory).

For ease of understanding, the following specifically describes the communication method provided in embodiments of this application with reference to FIG. 4 to FIG. 7.

For example, for the foregoing problem A, FIG. 4 is a schematic flowchart 1 of a communication method according to an embodiment of this application. The method may be performed by a transmitting device. The "transmitting device" in embodiments of this application may be the transmitting device (for example, a network device or a terminal device), may be a component (for example, a processor, a chip, or a chip system) in the transmitting device, or may be a logical module or software that can implement all or a part of functions of the transmitting device. This is not limited. For example, the transmitting device may be the network device or the terminal device shown in FIG. 2.

Specifically, as shown in FIG. 4, a procedure of the communication method is as follows.

S401: A transmitting side determines a first code block segmentation length.

In this embodiment of this application, a base matrix is locally stored in the transmitting device and a receiving device. For the transmitting device, the base matrix may be used to perform LDPC encoding on data (a to-be-transmitted data block). For the receiving device, the base matrix may be used to decode data. The base matrix may be a base matrix corresponding to a check matrix used for encoding or decoding. Alternatively, the base matrix may be a base matrix corresponding to a check matrix that is used for encoding or decoding and that is obtained through transformation processing (for example, elimination, puncturing, or merging). The base matrix is lifted/extended to obtain the parity-check matrix. This is not limited.

The first code block segmentation length may be used to perform code block segmentation on the to-be-transmitted data block. The to-be-transmitted data block may be a to-be-channel-encoded data block received by the transmitting side. It may be understood that the to-be-transmitted data block, the to-be-channel-encoded data block, a transmitted data block, and the like may be replaced with each other. This is not limited.

The first code block segmentation length may be determined based on a number of information columns of the base matrix and a lifting size in a set of lifting sizes corresponding to the base matrix. The first code block segmentation length may satisfy the following relationship: $K_{cb}=K_b \times Z_c$, where $K_{cb}$ is the first code block segmentation length, $K_b$ is the number of information columns, and $Z_c$ is the lifting size.

The following describes a value of $K_b$ in detail.

In a possible design solution, a code rate is less than or equal to a first code rate, and the number of information columns is determined based on a minimum code rate and a maximum number of information columns.

The code rate may be denoted as R. R may be determined by using a formula R=K/N. K is a number of bits included in the to-be-transmitted data block, or K is a number of information bits. N is a code length, and the length N may be a sum of the number of bits included in the to-be-transmitted data block and a number of check bits, or the length N may be a sum of the number of information bits and a number of redundant bits.

It should be understood that the code rate may alternatively be a code rate, encoding efficiency, an encoding speed, or any other possible name. This is not limited.

The first code rate may be a preset value. For example, the first code rate may be 1/3. This is not limited. That the code rate is less than or equal to the first code rate may be understood as that a current scenario is a low rate service scenario, for example, an ultra-reliable and low-latency connection service scenario. In other words, in the low rate service scenario, the number of information columns may be determined based on the minimum code rate and the maximum number of information columns.

The minimum code rate may be a minimum code rate that can be supported by the transmitting side. If the transmitting side performs channel encoding on the to-be-transmitted data block by using the minimum code rate, accuracy of information in the data block that can be obtained by a receiving side through decoding can meet a communication requirement of a current service; or if the transmitting side performs channel encoding on the to-be-transmitted data block by using a code rate less than the minimum code rate, a receiving side cannot obtain information in the data block through decoding, or accuracy of information in the data block that is obtained through decoding cannot meet a communication requirement of a current service. In other words, the minimum code rate may be understood as a critical value of the code rate. A value of the minimum code rate may be a preset value. For example, the value of the minimum code rate may be predefined or preconfigured according to a protocol. For example, the value of the minimum code rate may be 1/5. This is not limited.

The maximum number of information columns may be a maximum number of information columns that can be supported by the transmitting side during channel encoding. A value of the maximum number of information columns may be a preset value. For example, the maximum number of information columns may be predefined or preconfigured according to the protocol. For example, the value of the maximum number of information columns may be 42. This is not limited.

It may be understood that the code rate is greater than or equal to the minimum code rate, and the number of information columns is less than or equal to the maximum number of information columns. This is not limited.

Optionally, the minimum code rate may satisfy any one of the following relationships:

$$R_{min} = \frac{K_b}{K_b + K_{b\max} - 2}, \quad K_b = \left\lfloor (K_{b\max} - 2)\left(\frac{R_{min}}{1-R_{min}}\right)\right\rfloor, \quad K_b = \left\lceil (K_{b\max} - 2)\left(\frac{R_{min}}{1-R_{min}}\right)\right\rceil,$$

or

$$K_b = (K_{b\max} - 2)\left(\frac{R_{min}}{1-R_{min}}\right).$$

$R_{min}$ is the minimum code rate. $K_b$ is the number of information columns. $K_{b\max}$ is the maximum number of information columns.

For example, if $R_{min}$=1/5, and $K_{b\max}$=42, $K_b = (42 - 2)\left(\frac{1/5}{1-1/5}\right) = 10$.

The number of information columns may be a number of columns corresponding to A shown in FIG. 1B. The number of information columns may be calculated starting from a 1st column corresponding to A. Alternatively, the number of information columns may be calculated starting from a column that is actually not punctured. For example, a 1st column and a 2nd column in A are punctured. In this case, the number of information columns may be calculated starting from a 3rd column. This is not limited.

In a possible design solution, the number of information columns is determined based on a code rate.

It may be understood that in a high rate service scenario, for example, a high throughput service scenario, the number of information columns may be determined based on the code rate.

For example, a relationship between the number of information columns and the code rate satisfies any one of the following: When the code rate is less than or equal to 0.875, the value of the number of information columns is 14; when the code rate is greater than 0.875 and less than or equal to 0.9, the value of the number of information columns is 18; when the code rate is greater than 0.9 and less than or equal to 0.917, the value of the number of information columns is 22; or when the code rate is greater than 0.917 and less than or equal to 0.926, the value of the number of information columns is 26. In this way, the transmitting side can accurately determine, based on a value range of the code rate, the number of information columns in the high throughput service scenario, improving code block segmentation accuracy. In other words, the relationship between the number of information columns and the code rate may be determined by using Table 1 below.

Table 1

| Code rate R | Number $K_b$ of information columns |
|---|---|
| 0.917<R≤0.926 | 26 |
| 0.9<R≤0.917 | 22 |
| 0.875<R≤0.9 | 18 |
| R≤0.875 | 14 |

The relationship between the number of information columns and the code rate is merely an example. The relationship between the number of information columns and the code rate may alternatively meet another condition. This is not limited. For example, the relationship between the number of information columns and the code rate may alternatively satisfy any one of the following: When the code rate is greater than 0.875 and less than or equal to 0.9, the value of the number of information columns is 14; when the code rate is greater than 0.9 and less than or equal to 0.917, the value of the number of information columns is 18; when the code rate is greater than 0.917 and less than or equal to 0.926, the value of the number of information columns is 22; or when the code rate is greater than 0.926, the value of the number of information columns is 26. In other words, the relationship between the number of information columns and the code rate may be determined by using Table 2 below.

Table 2

| Code rate R | Number $K_b$ of information columns |
|---|---|
| R>0.926 | 26 |
| 0.917<R≤0.926 | 22 |
| 0.9<R≤0.917 | 18 |
| 0.875<R≤0.9 | 14 |

It may be understood that Table 1 and Table 2 are merely examples, and the relationship between the number of information columns and the code rate may alternatively be determined in another manner. This is not limited.

In a possible design solution, the number of information columns is a preset value, that is, the number of information columns may be predefined or preconfigured. The transmitting side may directly determine the first code block segmentation length by using the predefined or preconfigured number of information columns. An implementation process is simple. For example, the value of the number of information columns is set to 5, and the transmitting side may directly determine the first code block segmentation length by using 5. This is not limited.

The following describes a value of $Z_c$ in detail.

In a possible design solution, the lifting size is a preset value, that is, the lifting size may be predefined or preconfigured. The transmitting side may directly determine the first code block segmentation length by using the predefined or preconfigured lifting size. An implementation process is simple. For example, the value of the lifting size is set to 384, and the transmitting side may directly determine the first code block segmentation length by using 384. This is not limited.

In a possible design solution, corresponding to sending of the to-be-transmitted data block by a terminal device to a network device, the lifting size is a first lifting size. Alternatively, corresponding to sending of the to-be-transmitted data block by a network device to a terminal device, the lifting size is a second lifting size. A maximum value of the first lifting size is greater than a maximum value of the second lifting size. In other words, if the to-be-transmitted data block is uplink data, the lifting size may belong to a set of lifting sizes of an uplink base matrix; or if the to-be-transmitted data block is downlink data, the lifting size may belong to a set of lifting sizes of a downlink base matrix.

It may be understood that decoding capabilities of the network device and the terminal device are different, and a maximum decoding code length that can be supported by the network device is greater than a maximum decoding code length that can be supported by the terminal device. Therefore, the maximum value of the first lifting size is greater than the maximum value of the second lifting size. The transmitting side may flexibly select the lifting size based on whether the to-be-transmitted data block is an uplink data block or a downlink data block, to match a decoding capability of the receiving side. This improves encoding efficiency of the transmitting side and decoding efficiency of the receiving side, further improving communication efficiency.

Optionally, a number of values of the first lifting size is greater than a number of values of the second lifting size, or in other words, a number of lifting sizes in the set of lifting sizes of the uplink base matrix is greater than a number of lifting sizes in the set of lifting sizes of the downlink base matrix. For example, the value of the first lifting size is any one of the following: 416, 448, 512, 1024, 115, 1536, 1920, or 2048; and the value of the second lifting size is any one of the following: 384 or 512. In this way, the terminal device may determine one of the values of the first lifting size as a lifting size on an uplink data channel, or the network device may determine one of the values of the second lifting size as a lifting size on a downlink data channel, to subsequently determine a corresponding first code block segmentation length.

For example, the first lifting size is 2048, and the second lifting size is 512. In this case, when performing channel encoding on the to-be-transmitted data block on a physical uplink shared channel (physical uplink shared channel, PUSCH), the transmitting side may determine the first code block segmentation length by using 2048 as the lifting size. When performing channel encoding on the to-be-transmitted data block on a physical downlink shared channel (physical downlink shared channel, PDSCH), the transmitting side may determine the first code block segmentation length by using 512 as the lifting size.

It should be understood that the value of the first lifting size may alternatively be any other possible value, and the value of the second lifting size may alternatively be any other possible value. This is not limited.

In this case, the transmitting side may determine the number $K_b$ of information columns and the lifting size $Zc$ in the foregoing manner, and determine the first code block segmentation length according to $K_{cb}=K_b \times Zc$. It may be understood that the transmitting side may alternatively determine a to-be-determined code block segmentation length set based on a set of numbers $K_b$ of information columns and a set of lifting sizes $Zc$, and then the transmitting side determines the first code block segmentation length from the code block segmentation length set. This is not limited.

In a possible design solution, corresponding to a first communication service type, the transmitting side may perform LDPC encoding on the to-be-transmitted data block. The first communication service type satisfies any one of the following:

the number of bits included in the to-be-transmitted data block is less than or equal to a first bit value, and the code rate is less than or equal to a second code rate; or
a mother code length is less than or equal to a first code length, and the code rate is less than or equal to a third code rate, where the mother code length is a code block length of the encoded to-be-transmitted data block.

The following uses the following two cases as examples to provide specific descriptions about that the number of bits included in the to-be-transmitted data block is less than or equal to the first bit value, and the code rate is less than or equal to the second code rate.

Case 1: Corresponding to the base matrix including a first base graph BG 1, the number of bits included in the to-be-transmitted data block is greater than 3824 (K3), the number of bits included in the to-be-transmitted data block is less than or equal to 8448 (K4), the code rate is greater than 0.25 (R1), and the code rate is less than or equal to 0.67 (R3); or the number of bits included in the to-be-transmitted data block is greater than 140 (K1), the number of bits included in the to-be-transmitted data block is less than or equal to 8448 (K4), the code rate is greater than 0.67 (R3), and the code rate is less than or equal to 0.9258 (R4, 948/1024).

The values of K1, K3, K4, R1, R3, and R4 are merely examples. K1, K3, K4, R1, R3, and R4 may alternatively be any other possible values. This is not limited.

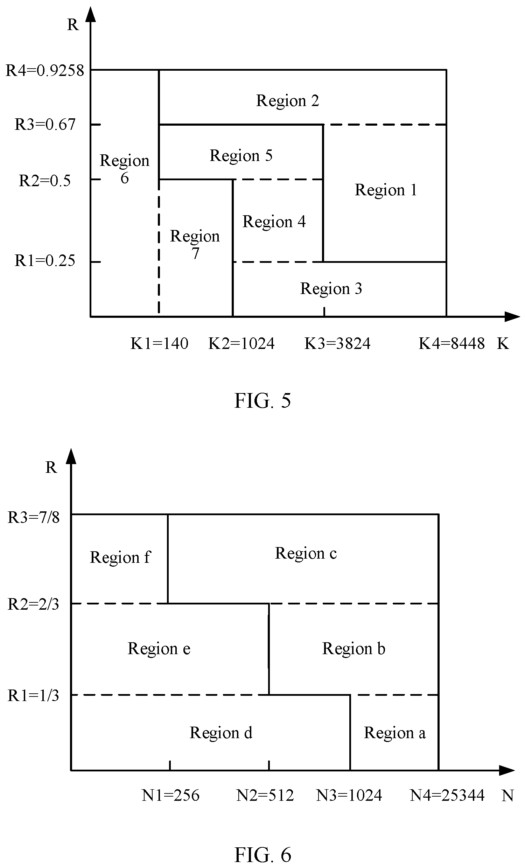

For example, FIG. 5 is a diagram 1 of region division corresponding to a data channel encoding mode. As shown in FIG. 5, a vertical axis is the code rate (code-rate) R, and a horizontal axis is the number K of bits included in the to-be-transmitted data block (or a payload size (payload size)). In this case, the first base graph BG 1 may correspond to a region 1 and a region 2 in FIG. 5. In the region 1, the number of bits included in the to-be-transmitted data block is greater than 3824 and less than or equal to 8448, and the code rate is greater than 0.25 and less than or equal to 0.67. In the region 2, the number of bits included in the to-be-transmitted data block is greater than 140 and less than or equal to 8448, and the code rate is greater than 0.67 and less than or equal to 0.9258. In other words, when the number of bits included in the to-be-transmitted data block and the code rate belong to the region 1 or the region 2, the transmitting side may encode the to-be-transmitted data block by using the BG 1.

It may be understood that "less than or equal to" may alternatively be "less than", and "greater than" may alternatively be "greater than or equal to". This is not limited. For example, that the number of bits included in the to-be-transmitted data block is greater than 3824, the number of bits included in the to-be-transmitted data block is less than or equal to 8448, the code rate is greater than 0.25, and the code rate is less than or equal to 0.67 may alternatively be: The number of bits included in the to-be-transmitted data block is greater than or equal to 3824, the number of bits included in the to-be-transmitted data block is less than 8448, the code rate is greater than or equal to 0.25, and the code rate is less than 0.67.

Case 2: Corresponding to the base matrix including a second base graph BG 2, the number of bits included in the to-be-transmitted data block is greater than 1024 (K2), the number of bits included in the to-be-transmitted data block is less than or equal to the third bit value 8448 (K4), and the code rate is less than or equal to 0.25 (R1);

the number of bits included in the to-be-transmitted data block is greater than 1024 (K2), the number of bits included in the to-be-transmitted data block is less than or equal to 3824 (K3), the code rate is greater than 0.25 (R1), and the code rate is less than or equal to 0.5 (R2); or

the number of bits included in the to-be-transmitted data block is greater than 140 (K1), the number of bits included in the to-be-transmitted data block is less than or equal to 3824 (K3), the code rate is greater than 0.5 (R2), and the code rate is less than or equal to 0.67 (R3).

The values of K1, K2, K3, K4, R1, R2, and R3 are merely examples. K1, K2, K3, K4, R1, R2, and R3 may alternatively be any other possible values. This is not limited. For example, K1=140 is a payload size corresponding to an LDPC short code interval $K_b$=6, and is also a maximum payload size of polar code encoded downlink control information (downlink control information, DCI). Alternatively, the value of K1 may be 544, that is, a payload size corresponding to an LDPC short code interval $K_b$=9. Alternatively, the value of K1 may be 624, that is, a payload size corresponding to an LDPC short code interval $K_b$=10.

For example, as shown in FIG. 5, the first base graph BG 2 may correspond to a region 3, a region 4, and a region 5. In the region 3, the number of bits included in the to-be-transmitted data block is greater than 1024 and less than or equal to 3824, and the code rate is less than or equal to 0.25. In the region 4, the number of bits included in the to-be-transmitted data block is greater than 1024 and less than or equal to 38224, and the code rate is greater than 0.25 and less than or equal to 0.5. In the region 5, the number of bits included in the to-be-transmitted data block is greater than 384 and less than or equal to 3824, and the code rate is greater than 0.5 and less than or equal to 0.67. In other words, when the number of bits included in the to-be-transmitted data block and the code rate belong to the region 3, the region 4, or the region 5, the transmitting side may encode the to-be-transmitted data block by using the BG 2.

It may be understood that "less than or equal to" may alternatively be "less than", and "greater than" may alternatively be "greater than or equal to". This is not limited. For example, that the number of bits included in the to-be-transmitted data block is greater than 140, the number of bits included in the to-be-transmitted data block is less than or equal to 3824, the code rate is greater than 0.5, and the code rate is less than or equal to 0.67 may alternatively be: The number of bits included in the to-be-transmitted data block is greater than or equal to 384, the number of bits included in the to-be-transmitted data block is less than 3824, the code rate is greater than or equal to 0.5, and the code rate is less than 0.67.

The following uses the following Case 3 as an example to provide specific descriptions about that the mother code length is less than or equal to the first code length, and the code rate is less than or equal to the third code rate.

The mother code length may be understood as a length obtained after channel encoding is performed on the to-be-transmitted data block, that is, an initial code length before rate matching. The initial code length may be $N=2^{\lceil \log_2 E \rceil}$, where E (E<N) is a length obtained after rate matching such as puncturing or shortening is performed on the mother code length N.

Case 3: The mother code length is greater than 1024 (N3), a code length of the to-be-transmitted data block is less than or equal to 25344 (N4), and the code rate is less than or equal to 1/3 (R1);

the mother code length is greater than 512 (N2), the mother code length is less than or equal to 25344 (N4), the code rate is greater than 1/3 (R1), and the code rate is less than or 2/3 (R2); or

the mother code length is greater than 256 (N1), the mother code length is less than or equal to 25344 (N4), the code rate is greater than 2/3 (R2), and the code rate is less than or equal to 7/8 (R3).

The values of N1, N2, N3, N4, R1, R2, and R3 are merely examples. N1, N2, N3, N4, R1, R2, and R3 may alternatively be any other possible values. This is not limited.

For example, FIG. 6 is a diagram 2 of region division corresponding to a data channel encoding mode. As shown in FIG. 6, a vertical axis is the code rate R (code-rate), and a horizontal axis is the mother code length N. In this case, that the mother code length is less than or equal to the first code length, and the code rate is less than or equal to the third code rate may correspond to a region a, a region b, and a region c in FIG. 6. In the region a, the mother code length is greater than 1024, the code length is less than or equal to 25344, and the code rate is less than or equal to 1/3. In the region b, the mother code length is greater than 512 and less than or equal to 25344, the code rate is greater than 1/3, and the code rate is less than or equal to 2/3. In the region c, the mother code length is greater than 256 and less than or equal to 25344, and the code rate is greater than 2/3 and less than or equal to 7/8. In other words, when the mother code length and the code rate belong to the region a, the region b, or the region c, the transmitting side may encode the to-be-transmitted data block by using an LDPC code.

It may be understood that "less than or equal to" may alternatively be "less than", and "greater than" may alternatively be "greater than or equal to". This is not limited. For example, that the mother code length is greater than 512, the mother code length is less than or equal to 25344, the code rate is greater than 1/3, and the code rate is less than or equal to 2/3 may alternatively be: The mother code length is greater than or equal to 512, the mother code length is less than 25344, the code rate is greater than or equal to 1/3, and the code rate is less than 2/3.

The region a, the region b, and the region c in FIG. 6 may be further divided into regions. For example, the region a, the region b, and the region c are divided based on the base matrix being a BG 1 or a BG 2. Details are not described herein.

It may be understood that in the region 1, the region 2, the region 3, the region 4, and the region 5 shown in FIG. 5, and in the region a, the region b, and the region c shown in FIG. 6, the transmitting side may encode the to-be-transmitted data block by using the LDPC code.

It may be understood that a name of the first code block segmentation length is merely an example, and the first code block segmentation length may alternatively be a first length, a code block segmentation length #1, or the like. This is not limited.

S402: The transmitting side segments the to-be-transmitted data block based on the first code block segmentation length.

The following uses the following scenarios as examples for specific description.

Scenario 1: The current scenario is an ultra-reliable and low-latency connection scenario. It is set that a length (the number of bits included) of the to-be-transmitted data block is B1, a current code rate is R, and a first code rate threshold R1 is 1/5.

1. If R<R1, the transmitting side determines values of a number $K_{b1}$ of information columns and a lifting size $Z_{c1}$.

If R is 1/8, 1/8<1/5, and the transmitting side determines that the value of $K_{b1}$ may be 5 and the value of $Z_{c1}$ may be 384.

1.1. $K_{cb1}=K_{b1} \times Z_{c1}=5\times384=1920$ is determined based on $K_{b1}$ and $Z_{c1}$.
1.2. Code block segmentation is performed on the to-be-transmitted data block based on $K_{cb1}$.

The transmitting side may determine, according to $C1=\lceil B1/K_{cb1}\rceil$, a number of segments obtained through code block segmentation. If B1 is 7680, $C=\lceil B1/K_{cb1}\rceil=7680/1920=4$. In other words, the transmitting side divides the to-be-transmitted data block into four code blocks with a length of 1920.

2. If R≥R1, the to-be-transmitted data block is segmented in an existing code block segmentation manner. In other words, the transmitting side performs segmentation based on 8448 or 3840. For specific descriptions, refer to the descriptions of a related part in the foregoing technical terms. Details are not described again.

It may be understood that the scenario 1 may be represented by using the following pseudocode:

> to-be-segmented data is an input sequence with a length of equal to B1;
>
> if R<R1 (for example, R1=1/5)
>
>  $K_{b1}$=5; //Determine the number of information columns.
>
>  $Z_{c1}$=384; //Determine the lifting size of the base matrix.
>
>  $K_{cb1}=K_{b1} \times Z_{c1}$; //Determine the segmentation length $K_{cb1}$ based on the number of information columns and the lifting size of the base matrix.
>
>  $C1=\lceil B1/K_{cb1}\rceil$;
>
> else
>
>  existing standard practice
>
> end if

Scenario 2: The current scenario is a high throughput scenario. It is set that a length of the to-be-transmitted data block is B2, a current code rate is R, and a second code rate threshold R2 is 0.917.

1. If R>R2, the transmitting side determines values of a number $K_{b2}$ of information columns and a lifting size $Z_{c2}$.

If R is 0.95, 0.95>0.917, and the transmitting side determines that the value of $K_{b2}$ may be 26 and the value of $Z_{c2}$

may be 384.

1.1. $K_{cb2}=K_{b2} \times Z_{c2}=26 \times 384=9984$ is determined based on $K_{b2}$ and $K_{b2}$.
1.2. Code block segmentation is performed on the to-be-transmitted data block based on $K_{cb2}$.

The transmitting side may determine, according to $C2=\lceil B2/K_{cb2} \rceil$, a number of segments obtained through code block segmentation. If B2 is 19968, $C2=\lceil B2/ K_{cb2} \rceil=19968/9984=2$. In other words, the receiving side divides the to-be-transmitted data block into two code blocks with a length of 9984.

2. If R≤R2, the transmitting side determines values of a number $K_{b3}$ of information columns and a lifting size $Z_{c3}$.

If R is 0.91, 0.91<0.917, and the transmitting side determines that the value of $K_{b3}$ may be 22 and the value of $Z_{c3}$ may be 384.

2.1. $K_{cb3}=K_{b3} \times Z_{c3}=22 \times 384=8448$ is determined based on $K_{b3}$ and $Z_{c3}$.
2.2. Code block segmentation is performed on the to-be-transmitted data block based on $K_{cb3}$.

The transmitting side may determine, according to $C3=\lceil B2/K_{cb3} \rceil$, a number of segments obtained through code block segmentation. If B2 is 19968, $C3=\lceil B2/ K_{cb3} \rceil=19968/8448=3$. In other words, the transmitting side divides the to-be-transmitted data block into three code blocks with a length of 8448.

It may be understood that the scenario 2 may be represented by using the following pseudocode:

to-be-segmented data is an input sequence with a length equal to B2;

if R>R2 (for example, R2=0.917)

$K_{b2}$=26; //Determine the number of information columns.

$Z_{c2}$=384; //Determine the lifting size of the base matrix.

$K_{cb2}=K_{b2} \times Zc2$; //Determine the segmentation length based on the number of information columns and the lifting size of the base matrix.

$C2=\lceil B2/K_{cb2} \rceil$;

else

$K_{b3}$=22; //Determine the number of information columns.

$Z_{c3}$=384; //Determine the lifting size of the base matrix.

$K_{cb3}=K_{b3} \times Z_{c3}$; //Determine the segmentation length $K_{cb2}$ based on the number of information columns and the lifting size of the base matrix.

$C3=\lceil B2/K_{cb3} \rceil$;

end if

Scenario 3: The current scenario is an ultra-reliable and low-latency connection scenario. It is set that a length (the number of bits included) of the to-be-transmitted data block is B, a current code rate is R, and a third code rate threshold R3 is 1/5. In this case, a lifting size of an LDPC base matrix and a bit value of each segment are determined according to the following steps.

1. If R<R3, the transmitting side determines values of a number $K_{b4}$ of information columns and a lifting size $Z_{c4}$.

If R is 1/8, 1/8<1/5, and the transmitting side determines that the value of $K_{b4}$ may be 5. The value of $Z_{c4}$ may be determined according to Table 5.3.2-1 in the technical standard (technical specification, TS) 38.212, for example, $K_{b4}$

=384, so that $|K_{b4} \times Z_{c4}\text{-}B|$ has a minimum value.

    1.1. $K_{cb4} = K_{b4} \times Z_{c4} = 5 \times 384 = 1920$ is determined based on $K_{b4}$ and $Z_{c4}$.
    1.2. Code block segmentation is performed on the to-be-transmitted data block based on $K_{cb4}$.

The transmitting side may determine, according to $C=\lceil B/K_{cb4} \rceil$, a number of segments obtained through code block segmentation. If B is 2000, $C=\lceil B/K_{cb4} \rceil = \lceil 2000/1920 \rceil = 2$. In other words, the transmitting side divides the to-be-transmitted data block into two code blocks with a length of 1920.

2. A number of to-be-encoded bits is redetermined based on the number C of segments. Because C is a result of a ceiling operation, a sum of numbers of bits in the segments obtained through segmentation may be greater than the number B of bits before segmentation, that is, the sum of the numbers of bits in the segments obtained through segmentation is $B'=K_{cb4} \times Z_{c4} \times C = 1920 * 2 = 3840$. If B'>B, (B'-B)=1840 0s are added before B to-be-segmented bits, and remaining B=2000 bits are located in the last B locations.

For each segment of data obtained through segmentation, for example, an $r^{th}$ segment of data, r={0, 1, 2, ..., C-1}, a concatenated CRC operation is performed. A bit length of the $r^{th}$ segment is $K_r=K_{cb4} \times Z_{c4}$. L-bit CRC encoding is performed on $K_r$ bits of each segment, and L CRC check bit obtained through encoding are concatenated after $K_r$-bit data of each segment. It may be understood that a specific implementation of CRC encoding and the concatenated CRC operation may be implemented by reusing a manner in the conventional technology. Details are not described again.

It may be understood that the scenario 3 may be represented by using the following pseudocode:

if $R<1/5$

$K_{b4}=5$; //First determine the number of information columns.

Find a value of Zc making $|K_{b4} \times Z_{c4}\text{-}B|$ minimum in the standard;

$C=\lceil B/(K_{b4} \times Z_{c4}) \rceil$

$B'=(K_{b4} \times Z_{c4}) \times C$

for $i=0$ to B'–B–1

    $b'_i=0$;

end for

for $i=$B'–B to B'–1

    $b'_i=b'_{i-(B'-B)}$

end for

An output bit sequence of CB segmentation is denoted as $c_{r0}$, $c_{r1}$, $c_{r2}$, ... , $c_{r(Kr-1)}$, where $0 \leq r<C$ is a number of code blocks, $Kr=K_b \times Z_c$ is the number of segments, and a bit value $c_{rk}$ of each segment is determined as follows:

s=0

for $r=0$ to $C-1$

    for $k=0$ to $Kr-1-L$

        $c_{rk} = b'_s$;

        s=s+1;

    end for

The sequence $c_{r0}, c_{r1}, c_{r2}, \dots , c_{r(Kr-1)}$ is used to generate L CRC check bits $p_{r0}, p_{r1}, p_{r2}, \dots , p_{r(L-1)}$.

$$\text{for } k=K_r-\text{L to } K_r - 1$$

$$c_{rk} = p_{r(k-B_m)};$$

$$\text{end for}$$

$$\text{end for}$$

$$\text{else}$$

$$\text{existing standard practice;}$$

$$\text{end}$$

It may be understood that for a specific implementation process of the existing standard practice, refer to related content in Chapter 5 of TS 38.212. Details are not described again.

S403: The transmitting side performs LDPC encoding on the segmented to-be-transmitted data block to obtain encoded data.

It may be understood that in a specific implementation process in which the transmitting side performs LDPC encoding on the segmented to-be-transmitted data block, an existing LDPC encoding method may be reused. Details are not described again.

In conclusion, the transmitting side may dynamically determine the first code block segmentation length based on the number of information columns of the base matrix and the lifting size in the set of lifting sizes corresponding to the base matrix, to segment the to-be-transmitted data block. Compared with the existing code block segmentation manner in which the transmitting side directly uses a preselected fixed length $K_{cb}=3840$ or $K_{cb}=8448$ for segmentation, in this manner, the first code block segmentation length may be dynamically adjusted based on service scenario requirements. This implementation is more flexible, and can avoid errors or inapplicability of code block segmentation. Therefore, code block segmentation accuracy and communication reliability can be improved, to meet communication requirements in different service scenarios.

With reference to the foregoing embodiment, optionally, the method may further include:
corresponding to a second communication service type, the transmitting side encodes the to-be-transmitted data block by using a polar code.

A code rate corresponding to the second communication service type and the number of bits included in the to-be-transmitted data block satisfy at least one of the following:
the number of bits included in the to-be-transmitted data block is less than or equal to a second bit value, and the code rate is less than or equal to a fourth code rate.

The following uses Case 4 as an example for specific description.

Case 4: The number of bits included in the to-be-transmitted data block is less than or equal to 140 (K1), and the code rate is less than or equal to 0.9258 (R4); or
the number of bits included in the to-be-transmitted data block is greater than 140 (K1), the number of bits included in the to-be-transmitted data block is less than or equal to 1024 (K2), and the code rate is less than or equal to 0.5 (R2).

The values of K1, K2, R2, and R4 are merely examples. K1, K2, R2, and R4 may alternatively be any other possible values. This is not limited.

For example, as shown in FIG. 5, that the number of bits included in the to-be-transmitted data block is less than or equal to the second bit value, and the code rate is less than or equal to the fourth code rate may correspond to a region 6 and a region 7 in FIG. 5. In the region 6, the number of bits included in the to-be-transmitted data block is less than or equal to 140, and the code rate is less than or equal to 0.9258. In the region 7, the number of bits included in the to-be-transmitted data block is greater than 140, the number of bits included in the to-be-transmitted data block is less than or equal to 1024, and the code rate is less than or equal to 0.5. In other words, when the number of bits included in the to-be-transmitted data block and the code rate belong to the region 6 or the region 7, the transmitting side may encode the to-be-transmitted data block by using the polar code.

It may be understood that "less than or equal to" may alternatively be "less than", and "greater than" may alternatively be "greater than or equal to". This is not limited. For example, that the number of bits included in the to-be-transmitted data block is greater than 140, the number of bits included in the to-be-transmitted data block is less than or equal to 1024, and the code rate is less than or equal to 0.5 may alternatively be: The number of bits included in the to-be-transmitted data block is greater than or equal to 384, the number of bits included in the to-be-transmitted data block is less than 1024, and the code rate is less than 0.5.

In the region 6 and the region 7 shown in FIG. 5, a data packet on a data channel is a short packet, or in other words, the to-be-transmitted data block has a small code length and a low code rate. In this case, the transmitting side does not need to perform code block segmentation on the to-be-transmitted data block, and the transmitting side may directly perform encoding by using the polar code.

It may be understood that as shown in FIG. 5, the transmitting side may determine, based on a region to which the number of bits included in the to-be-transmitted data block and the code rate belong, an encoding mode or an encoding type corresponding to the data channel. For example, when the number of bits included in the to-be-transmitted data block and the code rate belong to the region 1, the region 2, the region 3, the region 4, or the region 5, the transmitting side may encode the to-be-transmitted data block by using the LDPC code. When the number of bits included in the to-be-transmitted data block and the code rate belong to the region 6 or the region 7, the transmitting side may encode the to-be-transmitted data block by using the polar code. In this way, a new encoding mode can be introduced to the data channel. Performance of the polar code is far better than that of the LDPC code, and the polar code has low computational complexity in terms of encoding and decoding. Therefore, data channel encoding and decoding performance can be improved. A specific implementation process in which the transmitting side encodes the to-be-transmitted data block by using the polar code is not limited in embodiments of this application.

For example, the following scenario is used as an example for specific description.

Scenario 4: As shown in FIG. 5, it is set that the number of bits included in the to-be-transmitted data block is A, and a current code rate is R.

If $K_1 < A \leq K_2$ and $R \leq R_2$, or $A \leq K_1$ and $R \leq R_4$, the transmitting side does not need to perform code block segmentation on the to-be-transmitted data block, and a number C of segments obtained through code block segmentation is 1.

If $K_2 < A \leq K_4$ and $R \leq R_1$, or $K_2 < A \leq K_3$ and $R_1 < R \leq R_2$, or $K_1 < A \leq K_3$ and $R_2 < R \leq R_3$, the code block segmentation length $K_{cb}$ is 3840, and the transmitting side segments the to-be-transmitted data block based on 3840.

If $K_3 < A \leq K_4$ and $R_1 < R \leq R_3$, or $K_1 < A \leq K_4$ and $R_3 < R \leq R_4$, the code block segmentation length $K_{cb}$ is 8448, and the transmitting side segments the to-be-transmitted data block based on 8448.

If $A \leq K_{cb}$, obtained through code block segmentation is 1, and a sum A' of numbers of bits in the segments obtained through segmentation is A; or if $A > K_{cb}$, obtained through code block segmentation is $\left\lceil \dfrac{B}{K_{cb}-L} \right\rceil$, a sum B' of numbers of bits in the segments obtained through segmentation is B+C·L, and a number K' of bits in each segment of data block obtained through segmentation is B'/C.

It may be understood that the scenario 4 may be represented by using the following pseudocode:

if $K_1 < A \leq K_2$ and $R \leq R_2\_2$, or $A \leq K_1$ and $R \leq R_4$;

No segmentation, C=1;

else if $K_2 < A \leq K_4$ and $R \leq R_1$, or $K_2 < A \leq K_3$ and $R_1 < R \leq R_2$, or $K_1 < A \leq K_3$

$K_1 < A \leq K_3$ and $R_2 < R \leq R_3$;

$K_{cb}$=3840, segment based on $K_{cb}$;

else

$K_{cb}$=8448, segment based on $K_{cb}$;

if $A \leq K_{cb}$;

L=0, Number of code blocks C=1; A'=A;

else

L=24, Number of code blocks: C=$\lceil$B/($K_{cb}$−L)$\rceil$ B'=B+C·L

The number of bits K in each code block is calculated as K'=B'/C;

Optionally, the method may further include:

corresponding to a second communication service type, the transmitting side segments the to-be-transmitted data block; and
the transmitting side encodes the to-be-transmitted data block by using a polar code.

The mother code length is a code block length of the encoded to-be-transmitted data block. It may be understood that for related descriptions of the mother code length, refer to the related descriptions in step S401. Details are not described again.

The second communication service type may satisfy a condition that the mother code length is less than or equal to a second code length and the code rate is less than or equal to a fifth code rate, where the mother code length is the code block length of the encoded to-be-transmitted data block. The following uses Case 5 as an example for specific description.

Case 5: The mother code length is less than or equal to 1024 (N3), and the code rate is less than or equal to 1/3 (R1);

the mother code length is less than or equal to 512 (N2), the code rate is greater than 1/3 (R1), and the code rate is less than or equal to 2/3 (R2); or

the mother code length is less than or equal to 256 (N1), the code rate is greater than 2/3 (R2), and the code rate is less than or equal to 7/8 (R3).

The values of N1, N2, N3, R1, R2, and R3 are merely examples. N1, N2, N3, R1, R2, and R3 may alternatively be any other possible values. This is not limited.

For example, as shown in FIG. 6, in this case, that the mother code length is less than or equal to the second code length and the code rate is less than or equal to the fifth code rate may correspond to a region d, a region e, and a region f in FIG. 6. In the region d, the mother code length is less than or equal to 1024, and the code rate is less than or equal to 1/3. In the region e, the mother code length is less than or equal to 512, the code rate is greater than 1/3, and the code rate is less than or equal to 2/3. In the region f, the mother code length is less than or equal to 256, the code rate is greater than 2/3, and the code rate is less than or equal to 7/8. In other words, when the mother code length and the code rate belong to the region d, the region e, or the region f, the transmitting side may encode the to-be-transmitted data block by using the polar code.

It may be understood that as shown in FIG. 6, the transmitting side may determine, based on a region to which the mother code length and the code rate belong, an encoding mode or an encoding type corresponding to the data channel. For example, when the mother code length and the code rate belong to the region a, the region b, or the region c, the transmitting side may encode the to-be-transmitted data block by using the LDPC code. When the mother code length and the code rate belong to the region d, the region e, or the region f, the transmitting side may encode the to-be-transmitted data block by using the polar code. In this way, a new encoding mode can be introduced to the data channel. Performance of the polar code is far better than that of the LDPC code, and the polar code has low computational complexity in terms of encoding and decoding. Therefore, data channel encoding and decoding performance can be improved.

It may be understood that before the transmitting side encodes the to-be-transmitted data block by using the polar code, the transmitting side needs to perform code block segmentation on the to-be-transmitted data block based on a second code block segmentation length.

The second code block segmentation length is determined based on the mother code length and the code rate.

The second code block segmentation length may satisfy the following relationship: $A=\lceil N_{max} \cdot R \rceil$ , where A is the second code block segmentation length, $N_{max}$ is the mother code length, and R is the code rate.

In this case, the transmitting side may determine the second code block segmentation length A based on a product of the mother code length $N_{max}$ and the code rate R, and perform code block segmentation on the to-be-transmitted data block by using the second code block segmentation length. For example, it is set that after retransmission, a corresponding maximum mother code length Nmax is 2048, and a maximum initial transmission code rate R is 0.5. In this case, the transmitting side may perform code segmentation on the to-be-transmitted data block by using

$$A=\lceil N_{max} \cdot R \rceil = 1024$$ as the second code block segmentation length.

It may be understood that a name of the second code block segmentation length is merely an example, and the second code block segmentation length may alternatively be a second length, a code block segmentation length #2, or the like. This is not limited.

A specific implementation process in which the transmitting side encodes the to-be-transmitted data block by using the polar code is not limited in embodiments of this application.

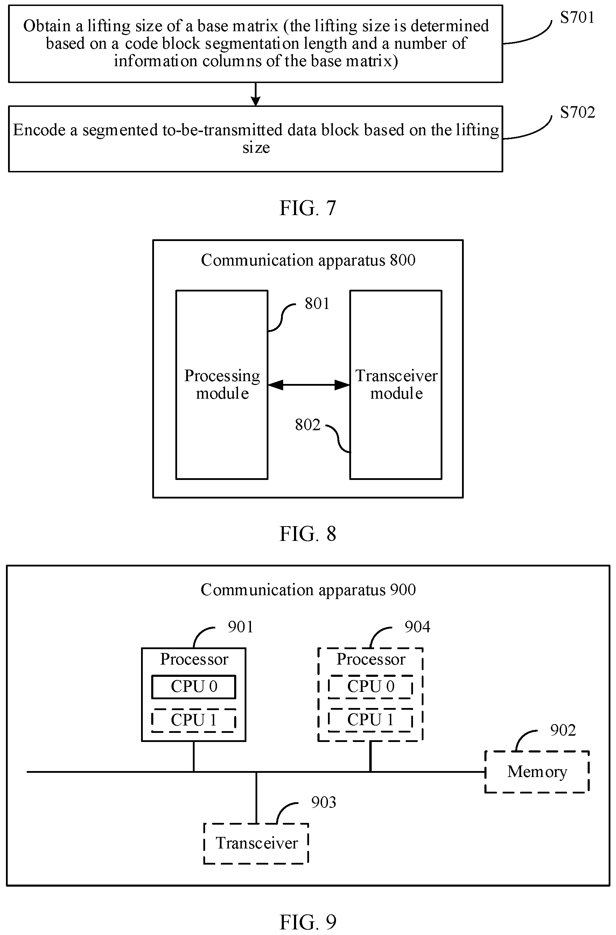

For example, for the foregoing problem B, FIG. 7 is a schematic flowchart 2 of a communication method according to an embodiment of this application. The method may be performed by a transmitting device. The "transmitting device" in embodiments of this application may be the transmitting device (for example, a network device or a terminal device), may be a component (for example, a processor, a chip, or a chip system) in the transmitting device, or may be a logical module or software that can implement all or a part of functions of the transmitting device. This is not limited. For example, the transmitting device may be the network device or the terminal device shown in FIG. 2.

Specifically, as shown in FIG. 7, a communication procedure is as follows.

S701: A transmitting side obtains a lifting size of a base matrix.

In this embodiment of this application, the base matrix is locally stored in the transmitting device and a receiving device. For the transmitting device, the base matrix may be used to perform LDPC encoding on data (a to-be-transmitted data block). For the receiving device, the base matrix may be used to decode data. The base matrix may be a base matrix corresponding to a check matrix used for encoding or decoding. Alternatively, the base matrix may be a base matrix corresponding to a check matrix that is used for encoding or decoding and that is obtained through transformation processing (for example, elimination, puncturing, or merging). The base matrix is lifted/extended to obtain the parity-check matrix. This is not limited. The base matrix is used to perform encoding processing on the to-be-transmitted data block.

The lifting size is determined based on a code block segmentation length and a number of information columns of the base matrix. The lifting size may satisfy the following relationship: $Z_c = \lceil K_{cb}/K_b \rceil$, where $Z_c$ is the lifting size, $K_{cb}$ is the code block segmentation length, and $K_b$ is the number of information columns.

The following describes a value of $K_{cb}$ in detail. The code block segmentation length may be a preset value. For example, the value of the code block segmentation length may be related to a type of the base matrix. If the base matrix is a first base matrix, the code block segmentation length may be a first preset value; or if the base matrix is a second base matrix, the code block segmentation length may be a second preset value. The first base matrix may be a BG 1, and the first preset value may be 8448. The second base matrix may be a BG 2, and the second preset value may be 3840. The transmitting side may determine, based on the type of the base matrix, that the code block segmentation length is 8448 or 3840, to subsequently perform code block segmentation on the to-be-transmitted data block by using 8448 or 3840.

The following describes a value of $K_b$ in detail.

In a possible design solution, the number of information columns is determined based on a minimum code rate and a maximum number of information columns, a code rate is greater than or equal to the minimum code rate, and the number of information columns is less than or equal to the maximum number of information columns. A first code rate may be a preset value, for example, 1/3. This is not limited.

Optionally, the number of information columns satisfies any one of the following relationships:

$$R_{min} = \frac{K_b}{K_b + K_{b\max} - 2}, \quad K_b = \left\lfloor (K_{b\max} - 2)\left(\frac{R_{min}}{1 - R_{min}}\right) \right\rfloor, \quad K_b = \left\lceil (K_{b\max} - 2)\left(\frac{R_{min}}{1 - R_{min}}\right) \right\rceil,$$

or

$$K_b = (K_{b\max} - 2)\left(\frac{R_{min}}{1 - R_{min}}\right).$$

$R_{min}$ is the minimum code rate, $K_b$ is the number of information columns, and $K_{b\max}$ is the maximum number of information columns. Values of $R_{min}$ and $K_{b\max}$ may be preset values.

In a possible design solution, the number of information columns is determined based on a code rate.

Optionally, a relationship between the number of information columns and the code rate satisfies any one of the following: When the code rate is less than or equal to 0.875, the value of the number of information columns is 14; when the code rate is greater than 0.875 and less than or equal to 0.9, the value of the number of information columns is 18; when the code rate is greater than 0.9 and less than or equal to 0.917, the value of the number of information columns is 22; or when the code rate is greater than 0.917 and less than or equal to 0.926, the value of the number of information columns is 26.

In a possible design solution, the number of information columns may be a preset value.

It may be understood that for a process of determining the number of information columns of the base matrix, refer to the related descriptions of the number of information columns in step S401. Details are not described.

The transmitting side may determine the code block segmentation length $K_{cb}$ and the number $K_b$ of information columns in the foregoing manner, and determine the lifting size of the base matrix according to $Z_c = \lceil K_{cb}/K_b \rceil$. For example, the code block segmentation length $K_{cb}$ is 3840, and the number $K_b$ of information columns is 6. In this case, the lifting size $Z_c$ is $\lceil 3840/6 \rceil = 640$.

S702: The transmitting side encodes the segmented to-be-transmitted data block based on the lifting size.

The transmitting side may generate a corresponding base matrix based on the determined lifting size, and extract different parts of the base matrix for extension into corresponding check matrices. The transmitting side encodes a to-be-transmitted information sequence at different code rates by using the check matrices.

It may be understood that a specific process in which the transmitting side encodes the segmented to-be-transmitted data block based on the lifting size is not limited in embodiments of this application.

In conclusion, the transmitting side may first determine the code block segmentation length based on a selected BG, and then dynamically adjust the lifting size of the base matrix by using the code block segmentation length and the number of information columns of the base matrix. In addition, the transmitting side encodes the segmented to-be-transmitted data block by using the lifting size of the base matrix. This implementation is more flexible, and can avoid occurrence of an error in an encoding process due to a small number of information columns. Therefore, data channel encoding accuracy can be improved, to meet communication requirements in different scenarios and improve communication efficiency.

With reference to the foregoing embodiment, optionally, before the transmitting side encodes the segmented to-be-transmitted data block based on the lifting size, the method may further include:

the transmitting side performs code block segmentation on the to-be-transmitted data block based on the code block segmentation length.

The transmitting side may first perform code block segmentation on the to-be-transmitted data block based on the code block segmentation length, for subsequent LDPC encoding. For example, if the selected base matrix is the BG 1, the code block segmentation length may be 8448, and the transmitting side may perform code block segmentation on the to-be-transmitted data block by using 8448; or if the selected base matrix is the BG 2, the code block segmentation length may be 3840, and the transmitting side may perform code block segmentation on the to-be-transmitted data block by using 3840.

A specific implementation process of code block segmentation is not limited in embodiments of this application.

With reference to the method embodiment, the foregoing describes an overall procedure of the communication method provided in embodiments of this application. For ease of understanding, the following describes the foregoing method by using the following specific scenario.

Scenario 5

(1) The BG 2 is selected. In this case, $K_{cb}$=3840.
(2) Code block segmentation is performed on the to-be-transmitted data block based on the code block segmentation length.

If a length B of the to-be-transmitted data block is less than or equal to $K_{cb}$, a value of a bit number L of CRC check bits is 0, a number C of segments obtained through code block segmentation is 1, and a sum B' of numbers of bits in the segments obtained through segmentation is B; or if a length B of the to-be-transmitted data block is greater than $K_{cb}$, number C of segments obtained through code block segmentation is $\left\lceil \dfrac{B}{K_{cb}-L} \right\rceil$, and a sum B' of numbers of bits in the segments obtained through segmentation is B+C·L.

The transmitting side may determine, according to K'=B'/C, a number K' of bits in each segment of data block obtained through segmentation.

(3) A smaller number of information columns is determined based on a current code rate.

For example, if the current code rate R<1/5, the transmitting side may select a smaller number of information columns, for example, $K_b$=5, or the transmitting side may determine $K_b$ according to TS. This is not limited.

(4) The lifting size of the base matrix is determined according to $Z_c = \left\lceil \dfrac{K_{cb}}{K_b} \right\rceil$.

If $Z_c$ is greater than all lifting sizes of the base matrix in Table 5.3.2-1 in TS 38.212, the lifting size of the base matrix $Z_c = \left\lceil \dfrac{K_{cb}}{K_b} \right\rceil$; or if $Z_c$ is not greater than all lifting sizes of the base matrix in Table 5.3.2-1 in TS 38.212, the transmitting side may determine a minimum lifting size of the base matrix in Table 5.3.2-1 in TS as Zc, so that $Z_c \times K_b \geq$ K'.

It may be understood that the scenario 5 may be represented by using the following pseudocode:

Step1) Select the BG 2, $K_{cb}=3840$.

Step2) Segment based on $K_{cb}$.

if $B \leq K_{cb}$;

L=0;

Number of code blocks C=1; B'=B;

else

L=24;

Number of code blocks: $C=\left\lceil \dfrac{B}{K_{cb}-L} \right\rceil$, B'=B+C·L;

end if

The number of bits K in each code block is calculated as K'=B'/C;

Step3) Determine a smaller number $K_b$ of information columns based on the code rate.

if R<1/5;

Select a smaller number of information columns, for example, $K_b=5$.

else

Determine $K_b$ according to an existing standard;

end if

Step4) Calculate $Z_c=\left\lceil \dfrac{K_{cb}}{K_b} \right\rceil$ to determine a proper lifting size.

if $Z_c$ is larger than all sets of lifting sizes in Table 5.3.2-1, then $Z_c=\left\lceil \dfrac{K_{cb}}{K_b} \right\rceil$;

else

find the minimum value of Z in all sets of lifting sized in Table 5.3.2-1, denoted as Zc,

such that $Z_c \times K_b \geq K'$;

end if

It may be understood that for a specific implementation process of the existing standard practice, refer to related content in Chapter 5 of TS 38.212. Details are not described.

In the foregoing method embodiments, an implementation process of code block segmentation is described by using the data channel as an example. The communication method may also be applicable to code block segmentation on another channel, for example, a control channel. An implementation principle of code block segmentation on the control channel is the same as an implementation principle of code block segmentation on the data channel. Refer to the implementation principle of code block segmentation on the data channel for understanding. Details are not described.

The foregoing mainly describes the solutions provided in this application. Correspondingly, this application further provides a communication apparatus. The communication apparatus is configured to implement various methods in the method embodiments. The communication apparatus may be the transmitting device in the method embodiments, an apparatus including the transmitting device, or a component that can be used in the transmitting device, for example, a chip or a chip system.

It may be understood that to implement the foregoing functions, the communication apparatus includes a hardware structure and/or a software module for performing a corresponding function. A person skilled in the art should be easily aware that units and algorithm steps in the examples described with reference to embodiments disclosed in this specification may be implemented in a form of hardware or in a form of a combination of hardware and computer software in this application. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the communication apparatus may be divided into functional modules based on the method embodiments. For example, each functional module may be obtained through division based on each corresponding function, or two or more functions may be integrated into one processing module. The integrated module may be implemented in a form of hardware, or may be implemented in a form of a software functional module. Division into modules in embodiments of this application is an example, and is merely logical function division. During actual implementation, there may be another division manner.

For example, the communication apparatus is the transmitting device in the method embodiments. FIG. 8 is a diagram of a structure of a communication apparatus according to an embodiment of this application. As shown in FIG. 8, the communication apparatus 800 includes a processing module 801 and a transceiver module 802. The processing module 801 is configured to perform a processing function of the transmitting device in the method embodiments. The transceiver module 802 is configured to perform a transceiver function of the transmitting device in the method embodiments.

All related content of each step in the method embodiments may be cited in function descriptions of a corresponding functional module. Details are not described herein again.

The communication apparatus 800 provided in this embodiment can perform the foregoing methods. Therefore, for technical effects that can be achieved by the communication apparatus 800, refer to the method embodiments. Details are not described herein again.

In a possible design solution, in this embodiment of this application, the transceiver module 802 may include a receiving module and a sending module (not shown in FIG. 8). The transceiver module is configured to implement a sending function and a receiving function of the communication apparatus 800.

In a possible design solution, the communication apparatus 800 may further include a storage module (not shown in FIG. 8), and the storage module stores a program or instructions. When the processing module 801 executes the program or the instructions, the communication apparatus 800 may perform the function of the transmitting device in the method shown in FIG. 4 or FIG. 7.

It should be understood that the processing module 801 in the communication apparatus 800 may be implemented by a processor or a processor-related circuit component, or may be a processor or a processing unit. The transceiver module 802 may be implemented by a transceiver or a transceiver-related circuit component, or may be a transceiver or a transceiver unit.

For example, FIG. 9 is a diagram of a structure of another communication apparatus according to an embodiment of this application. The communication apparatus may be a transmitting device, or may be a chip (system) or another part or component that may be disposed in a transmitting device. As shown in FIG. 9, the communication apparatus 900 may include a processor 901. In a possible design solution, the communication apparatus 900 may further include a memory 902 and/or a transceiver 903. The processor 901 is coupled to the memory 902 and the transceiver 903, for example, may be connected to the memory 902 and the transceiver 903 through a communication bus.

The following describes the components of the communication apparatus 900 in detail with reference to FIG. 9.

The processor 901 may be one processor, or may be a collective term of a plurality of processing elements. For example, the processor 901 is one or more central processing units (central processing units, CPUs), may be an application-specific integrated circuit (application-specific integrated circuit, ASIC), or may be one or more integrated circuits configured to implement embodiments of this application, for example, one or more microprocessors (digital signal processors, DSPs), or one or more field programmable gate arrays (field programmable gate arrays, FPGAs).

In a possible design solution, the processor 901 may perform various functions of the communication apparatus 900 by running or executing a software program stored in the memory 902 and invoking data stored in the memory 902.

During specific implementation, in an embodiment, the processor 901 may include one or more CPUs, for example, a CPU 0 and a CPU 1 shown in FIG. 9.

During specific implementation, in an embodiment, the communication apparatus 900 may alternatively include a plurality of processors, for example, the processor 901 and a processor 904 shown in FIG. 9. Each of the processors may be a single-core processor (single-CPU), or may be a multi-core processor (multi-CPU). The processor herein may be one or more devices, circuits, and/or processing cores configured to process data (for example, computer program instructions).

The memory 902 is configured to store the software program for performing the solutions of this application, and the processor 901 controls execution of the software program. For a specific implementation, refer to the method embodiments. Details are not described herein again.

In a possible design solution, the memory 902 may be but is not limited to a read-only memory (read-only memory, ROM) or another type of static storage device capable of storing static information and instructions, a random access memory (random access memory, RAM) or another type of dynamic storage device capable of storing information and instructions, an electrically erasable programmable read-only memory (electrically erasable programmable read-only memory, EEPROM), a compact disc read-only memory (compact disc read-only memory, CD-ROM) or another optical disk storage, optical disc storage (including a compressed optical disc, a laser disc, an optical disc, a digital versatile optical disc, a Blu-ray disc, and the like), a magnetic disk storage medium or another magnetic storage device, or any other medium capable of carrying or storing desired program code in a form of an instruction or a data structure and accessible by a computer. The memory 902 may be integrated with the processor 901, or may exist separately, and is coupled to the processor 901 through an interface circuit (not shown in FIG. 9) of the communication apparatus 900. This is not specifically limited in embodiments of this application.

The transceiver 903 is configured to communicate with another communication apparatus. For example, the communication apparatus 900 is a terminal device, and the transceiver 903 may be configured to communicate with an access network device or communicate with another terminal device. For another example, the communication apparatus 900 is a network device, and the transceiver 903 may be configured to communicate with a terminal device or communicate with another network device.

In a possible design solution, the transceiver 903 may include a receiver and a transmitter (not separately shown in FIG. 9). The receiver is configured to implement a receiving function, and the transmitter is configured to implement a sending function.

In a possible design solution, the transceiver 903 may be integrated with the processor 901, or may exist separately, and is coupled to the processor 901 through an interface circuit (not shown in FIG. 9) of the communication apparatus 900. This is not specifically limited in embodiments of this application.

The structure of the communication apparatus 900 shown in FIG. 9 does not constitute a limitation on the communication apparatus. An actual communication apparatus may include more or fewer components than those shown in the figure, or combine some components, or have different component arrangements.

In addition, for technical effects of the communication apparatus 900, refer to the technical effects of the methods in the method embodiments. Details are not described herein again.

An embodiment of this application further provides a computer-readable storage medium. The computer-readable storage medium stores a computer program or instructions. When the computer program or the instructions are executed by a computer, functions in the method embodiments are implemented.

An embodiment of this application further provides a computer program product. When the computer program product is executed by a computer, functions in the foregoing method embodiments are implemented.

All or some of the foregoing embodiments may be implemented by using software, hardware, firmware, or any combination thereof. When a software program is used to implement the foregoing embodiments, all or some of the foregoing embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or other programmable apparatuses. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk drive, or a magnetic tape), an optical medium (for example, a DVD), a semiconductor medium (for example, a solid state drive (solid state drive, SSD)), or the like.

A person of ordinary skill in the art may be aware that the units and algorithm steps in the examples described with reference to embodiments disclosed in this specification can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that for the purpose of convenient and brief description, for a detailed working process of the foregoing system, apparatus, and unit, refer to a corresponding process in the method embodiment. Details are not described herein again.

In the several embodiments provided in this application, it should be understood that the disclosed system, apparatus, and method may be implemented in other manners. For example, the foregoing apparatus embodiments are merely examples. For example, division into the units is merely logical function division. During actual implementation, there may be another division manner. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, the part contributing to the conventional technology, or a part of the technical solutions may be implemented in a form of a software product. The computer software product is stored in a storage medium, and includes several instructions for enabling a computer device (which may be a personal computer, a server, an access network device, or the like) to perform all or some of the steps of the methods described in embodiments of this application. The foregoing storage medium includes any medium that can store program code, such as a USB flash drive, a removable hard disk drive, a read-only memory (read-only memory, ROM), a random access memory (random access memory, RAM), a magnetic disk, or an optical disc.

Although this application is described with reference to embodiments, in a process of implementing this application that claims protection, a person skilled in the art may understand and implement another variation of the disclosed embodiments by viewing the accompanying drawings, disclosed content, and the appended claims. In the claims, "comprising" (comprising) does not exclude another component or another step, and "a" or "one" does not exclude a case of plurality. A single processor or another unit may implement several functions enumerated in the claims. Some measures are recorded in dependent claims that are different from each other, but this does not mean that these measures cannot be combined to produce a better effect.

**Claims**

1. A communication method, wherein the method comprises:

   determining a first code block segmentation length, wherein the first code block segmentation length is used to perform code block segmentation on a to-be-transmitted data block, the first code block segmentation length is determined based on a number of information columns of a base matrix and a lifting size in a set of lifting sizes corresponding to the base matrix, and the base matrix is used to perform low-density parity-check LDPC encoding on the to-be-transmitted data block;
   segmenting the to-be-transmitted data block based on the first code block segmentation length; and
   performing LDPC encoding on the segmented to-be-transmitted data block to obtain encoded data.

2. The method according to claim 1, wherein the first code block segmentation length satisfies the following relationship: $K_{cb}=K_b \times Z_c$, wherein $K_{cb}$ is the first code block segmentation length, $K_b$ is the number of information columns, and $Z_c$ is the lifting size.

3. The method according to claim 1 or 2, wherein the code rate is less than or equal to a first code rate, the number of information columns is determined based on a minimum code rate and a maximum number of information columns, the code rate is greater than or equal to the minimum code rate, and the number of information columns is less than or equal to the maximum number of information columns.

4. The method according to claim 3, wherein the number of information columns satisfies any one of the following relationships:

$$R_{min} = \frac{K_b}{K_b + K_{bmax} - 2}, \quad K_b = \left\lfloor (K_{bmax} - 2)\left(\frac{R_{min}}{1 - R_{min}}\right) \right\rfloor, \quad K_b = \left\lceil (K_{bmax} - 2)\left(\frac{R_{min}}{1 - R_{min}}\right) \right\rceil \quad, \text{ or}$$

$$K_b = (K_{bmax} - 2)\left(\frac{R_{min}}{1 - R_{min}}\right) \text{, wherein}$$

$R_{min}$ is the minimum code rate, $K_b$ is the number of information columns, and $K_{bmax}$ is the maximum number of information columns.

5. The method according to claim 1 or 2, wherein the number of information columns is determined based on the code rate.

6. The method according to claim 1 or 2, wherein a relationship between the number of information columns and the code rate satisfies any one of the following:

> when the code rate is less than or equal to 0.875, a value of the number of information columns is 14;
> when the code rate is greater than 0.875 and less than or equal to 0.9, a value of the number of information columns is 18;
> when the code rate is greater than 0.9 and less than or equal to 0.917, a value of the number of information columns is 22; or
> when the code rate is greater than 0.917 and less than or equal to 0.926, a value of the number of information columns is 26.

7. The method according to any one of claims 1 to 6, wherein

> corresponding to sending of the to-be-transmitted data block by a terminal device to a network device, the lifting size is a first lifting size; or
> corresponding to sending of the to-be-transmitted data block by a network device to a terminal device, the lifting size is a second lifting size, wherein
> a maximum value of the first lifting size is greater than a maximum value of the second lifting size.

8. The method according to claim 7, wherein a number of values of the first lifting size is greater than a number of values of the second lifting size.

9. The method according to claim 7 or 8, wherein the value of the first lifting size is any one of the following: 416, 448, 512, 1024, 115, 1536, 1920, or 2048; and the value of the second lifting size is any one of the following: 384 or 512.

10. The method according to any one of claims 1 to 9, wherein corresponding to a first communication service type, the first communication service type satisfies any one of the following:

> a number of bits comprised in the to-be-transmitted data block is less than or equal to a first bit value, and the code rate is less than or equal to a second code rate; or
> a mother code length is less than or equal to a first code length, and the code rate is less than or equal to a third code rate, wherein the mother code length is a code block length of the encoded to-be-transmitted data block.

11. The method according to claim 10, wherein corresponding to the base matrix comprising a first base graph BG 1, that the number of bits comprised in the to-be-transmitted data block is less than or equal to the first bit value, and the code rate is less than or equal to the second code rate comprises:

> the number of bits comprised in the to-be-transmitted data block is greater than 3824, the number of bits comprised in the to-be-transmitted data block is less than or equal to 8448, the code rate is greater than 0.25, and the code rate is less than or equal to 0.67; or
> the number of bits comprised in the to-be-transmitted data block is greater than 140, the number of bits comprised in the to-be-transmitted data block is less than or equal to 8448, the code rate is greater than 0.67, and the code rate is less than or equal to 0.9258.

12. The method according to claim 10, wherein corresponding to the base matrix comprising a second base graph BG 2, that the number K of bits comprised in the to-be-transmitted data block is less than or equal to the first bit value, and the code rate is less than or equal to the second code rate comprises:

> the number of bits comprised in the to-be-transmitted data block is greater than 1024, the number of bits comprised in the to-be-transmitted data block is less than or equal to the third bit value 8448, and the code rate is less than or equal to 0.25;
> the number of bits comprised in the to-be-transmitted data block is greater than 1024, the number of bits comprised in the to-be-transmitted data block is less than or equal to 3824, the code rate is greater than 0.25, and the code rate is less than or equal to 0.5; or

the number of bits comprised in the to-be-transmitted data block is greater than 140, the number of bits comprised in the to-be-transmitted data block is less than or equal to 3824, the code rate is greater than 0.5, and the code rate is less than or equal to 0.67.

13. The method according to claim 10, wherein that the mother code length is less than or equal to the first code length, and the code rate is less than or equal to the third code rate comprises:

the mother code length is greater than 1024, a code length of the to-be-transmitted data block is less than or equal to 25344, and the code rate is less than or equal to 1/3;

the mother code length is greater than 512, the mother code length is less than or equal to 25344, the code rate is greater than 1/3, and the code rate is less than or equal to 2/3; or

the mother code length is greater than 256, the mother code length is less than or equal to 25344, the code rate is greater than 2/3, and the code rate is less than or equal to 7/8.

14. The method according to any one of claims 1 to 13, wherein the method further comprises:

corresponding to a second communication service type, encoding the to-be-transmitted data block by using a polar code, wherein

a code rate corresponding to the second communication service type and the number of bits comprised in the to-be-transmitted data block satisfy at least one of the following:

the number of bits comprised in the to-be-transmitted data block is less than or equal to a second bit value, and the code rate is less than or equal to a fourth code rate.

15. The method according to claim 14, wherein that the number of bits comprised in the to-be-transmitted data block is less than or equal to the second bit value, and the code rate is less than or equal to the fourth code rate comprises:

the number of bits comprised in the to-be-transmitted data block is less than or equal to 140, and the code rate is less than or equal to 0.9258; or

the number of bits comprised in the to-be-transmitted data block is greater than 140, the number of bits comprised in the to-be-transmitted data block is less than or equal to 1024, and the code rate is less than or equal to 0.5.

16. The method according to any one of claims 1 to 13, wherein the method further comprises:

corresponding to a second communication service type, segmenting the to-be-transmitted data block; and encoding the to-be-transmitted data block by using a polar code, wherein

the second communication service type satisfies a condition that the mother code length is less than or equal to a second code length and the code rate is less than or equal to a fifth code rate, wherein the mother code length is the code block length of the encoded to-be-transmitted data block.

17. The method according to claim 16, wherein that the mother code length is less than or equal to the second code length and the code rate is less than or equal to the fifth code rate comprises:

the mother code length is less than or equal to 1024, and the code rate is less than or equal to 1/3;

the mother code length is less than or equal to 512, the code rate is greater than 1/3, and the code rate is less than or 2/3; or

the mother code length is less than or equal to 256, the code rate is greater than 2/3, and the code rate is less than or equal to 7/8.

18. The method according to claim 16 or 17, wherein the segmenting the to-be-transmitted data block comprises: performing code block segmentation on the to-be-transmitted data block based on a second code block segmentation length, wherein the second code block segmentation length is determined based on the mother code length and the code rate.

19. The method according to claim 18, wherein the second code block segmentation length satisfies the following relationship: $A = \lceil N_{max} \cdot R \rceil$, wherein A is the second code block segmentation length, $N_{max}$ is the mother code length, and R is the code rate.

20. A communication apparatus, wherein the communication apparatus comprises a processor, and when the processor executes computer instructions, the communication apparatus is enabled to perform the method according to any one of claims 1 to 19.

21. A computer-readable storage medium, wherein the computer-readable storage medium comprises a computer program or instructions, and when the computer program or the instructions are run on a computer, the method according to any one of claims 1 to 19 is performed.

22. A computer program product, wherein the computer program product comprises a computer program or instructions, and when the computer program or the instructions are run on a communication apparatus, the method according to any one of claims 1 to 19 is performed.

FIG. 1A

FIG. 1B

Network device

Terminal device

FIG. 2

Transmitting device

| Source | → | Source encoding | → | Channel encoding | → | Modulation |

Receiving device

| Sink | ← | Source decoding | ← | Channel decoding | ← | Demodulation |

FIG. 3

Determine a first code block segmentation length (the first code block segmentation length is determined based on a number of information columns of a base matrix and a lifting size in a set of lifting sizes corresponding to the base matrix) — S401

Segment a to-be-transmitted data block based on the first code block segmentation length — S402

Perform LDPC encoding on the segmented to-be-transmitted data block to obtain encoded data — S403

FIG. 4

FIG. 5

FIG. 6

Obtain a lifting size of a base matrix (the lifting size is determined based on a code block segmentation length and a number of information columns of the base matrix) ⟋ S701

Encode a segmented to-be-transmitted data block based on the lifting size ⟋ S702

FIG. 7

Communication apparatus 800

Processing module  ⟋ 801

Transceiver module

802 ⟋

FIG. 8

Communication apparatus 900

⟋ 901
Processor
CPU 0
CPU 1

⟋ 904
Processor
CPU 0
CPU 1

⟋ 902
Memory

⟋ 903
Transceiver

FIG. 9

# EP 4 776 536 A1

## INTERNATIONAL SEARCH REPORT

| | International application No. |
|---|---|
| | **PCT/CN2023/124496** |

| **A.** | **CLASSIFICATION OF SUBJECT MATTER** |
|---|---|

H04L1/00(2006.01)i

According to International Patent Classification (IPC) or to both national classification and IPC

| **B.** | **FIELDS SEARCHED** |
|---|---|

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNTXT, ENTXT, DWPI, IEEE, 3GPP: 低密度奇偶校验码, LDPC, 基础图, 基图, 基矩阵, 提升, 因子, 值, 参数, 码块, 划分, 切分, 分段, 分割, 列, low-density parity-check, lifting value, lifting size, base matrix, base graph, code block, CB, segmentation, CBS

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| A | CN 110249537 A (IDAC HOLDINGS, INC.) 17 September 2019 (2019-09-17) description, paragraphs [0108]-[0240], and figure 4A | 1-22 |
| A | CN 110326222 A (TELEFONAKTIEBOLAGET LM ERICSSON (PUBL)) 11 October 2019 (2019-10-11) entire document | 1-22 |
| A | US 2020186167 A1 (LG ELECTRONICS INC.) 11 June 2020 (2020-06-11) entire document | 1-22 |
| A | US 2023179321 A1 (ZTE CORP.) 08 June 2023 (2023-06-08) entire document | 1-22 |
| A | TIAN, Yunke et al. "Low-Latency QC-LDPC Encoder Design for 5G NR" *Sensors*, 18 September 2021 (2021-09-18), section 2.1 | 1-22 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **30 May 2024** | **06 June 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2023/124496**

| Patent document cited in search report | | | Publication date (day/month/year) | Patent family member(s) | | | Publication date (day/month/year) |
|---|---|---|---|---|---|---|---|
| CN | 110249537 | A | 17 September 2019 | US | 2021384922 | A1 | 09 December 2021 |
| | | | | EP | 3577764 | A1 | 11 December 2019 |
| | | | | BR | 112019016156 | A2 | 24 March 2020 |
| | | | | JP | 2020511030 | A | 09 April 2020 |
| | | | | KR | 20230079251 | A | 05 June 2023 |
| | | | | US | 2020235759 | A1 | 23 July 2020 |
| | | | | RU | 2720950 | C1 | 15 May 2020 |
| | | | | TW | 201841485 | A | 16 November 2018 |
| | | | | WO | 2018144560 | A1 | 09 August 2018 |
| | | | | KR | 20190119036 | A | 21 October 2019 |
| | | | | HK | 40015982 | A0 | 04 September 2020 |
| CN | 110326222 | A | 11 October 2019 | WO | 2018143890 | A1 | 09 August 2018 |
| | | | | US | 2020235752 | A1 | 23 July 2020 |
| | | | | EP | 3577768 | A1 | 11 December 2019 |
| US | 2020186167 | A1 | 11 June 2020 | WO | 2018079987 | A1 | 03 May 2018 |
| US | 2023179321 | A1 | 08 June 2023 | JP | 2023534246 | A | 08 August 2023 |
| | | | | WO | 2022011592 | A1 | 20 January 2022 |
| | | | | EP | 4165807 | A1 | 19 April 2023 |
| | | | | MX | 2023000721 | A | 14 February 2023 |
| | | | | CN | 115836569 | A | 21 March 2023 |

Form PCT/ISA/210 (patent family annex) (July 2022)